# EUROPEAN PATENT SPECIFICATION

(11) **EP 1 548 836 B1**
(45) Date of publication and mention of the grant of the patent: **18.06.2008**
(21) Application number: 03792659.9
(22) Date of filing: 07.08.2003
(51) Int. Cl.: H01L 27/14, G01T 1/20, H04N 5/32

(54) **PHOTODIODE ARRAY AND RADIATION DETECTOR**
FOTODIODENARRAY UND STRAHLUNGSDETEKTOR
RESEAU DE PHOTODIODES ET DETECTEUR DE RAYONNEMENT

(30) Priority: 09.08.2002 JP 2002233562; 23.01.2003 JP 2003015318
(43) Date of publication of application: 29.06.2005
(60) Divisional application: 07013166.9
(73) Proprietor: HAMAMATSU PHOTONICS K. K., Hamamatsu-shi, Shizuoka 435-8558 (JP)
(72) Inventor: Shibayama, Katsumi, Hamamatsu-shi, Shizuoka 435-8558 (JP)
(74) Representative: Frost, Alex John
(86) International application number: PCT/JP2003/010093
(87) International publication number: WO 2004/019411

(56) References cited:
- EP-A- 0 279 492
- EP-A- 0 444 370
- EP-A- 0 768 720
- DE-A1- 4 102 285
- JP-A- 4 241 458
- JP-A- 5 150 049
- JP-A- 6 163 968
- JP-A- 10 223 873
- JP-A- 2001 291 892
- US-A- 4 814 847
- US-A- 5 852 322
- US-A1- 2002 011 640
- PATENT ABSTRACTS OF JAPAN vol. 1998, no. 13, 30 November 1998 (1998-11-30) & JP 10 223873 A (HAMAMATSU PHOTONICS KK), 21 August 1998 (1998-08-21)
- PATENT ABSTRACTS OF JAPAN vol. 2002, no. 02, 2 April 2002 (2002-04-02) & JP 2001 291892 A (HAMAMATSU PHOTONICS KK), 19 October 2001 (2001-10-19)

## Description

This invention concerns a photodiode array and a radiation detector.

### Background Art

In order to mount a photodiode array for CT, mounting in three-dimensional directions is required. To carry out mounting in three dimensions, signals must be output from the side opposite a light-incident surface, and thus generally, a back-illuminated photodiode array is used.

With a back-illuminated photodiode array, if the distance between pn junction parts and the light-incident surface is large, carriers generated inside a substrate recombine in the process of moving to the pn junction parts and cannot be taken out in the form of signals. Thus in order to improve the detection sensitivity, the distance between pn junction parts and the light-incident surface must be made as small as possible.

A back-illuminated photodiode array, with which this distance is made small, has been proposed (Japanese Published Unexamined Patent Application No. Hei 7-333348).

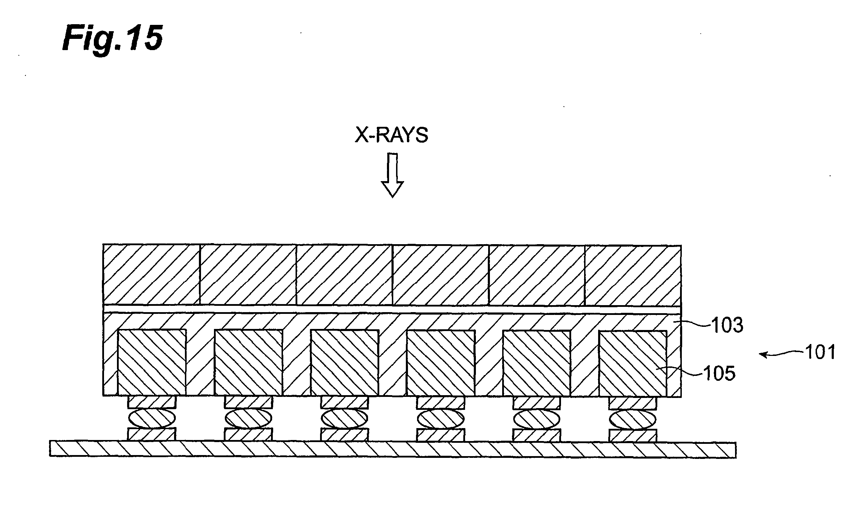

Fig. 15 is a sectional side view of this photodiode array.

With this photodiode array 101, p-type diffused layers 105 of prismatic shape are formed in an n-type layer 103 from one side of a substrate.

However, since p-type diffused layers 105 are formed by impurity implantation, it is difficult to form impurity layers uniformly to a thickness with which an adequate sensitivity can be obtained.

The above-mentioned photodiode array thus has the disadvantage of being difficult to manufacture.

Also, if the entire photodiode array is made thin, mechanical strength cannot be maintained and breakage occurs readily in subsequent processes.

A method of making the photodiode array a thin film at parts may thus be considered. That is, a method, wherein just the regions at which the photodiodes are formed are made thin to make the distance between the pn junction parts and the light-incident surface small while maintaining the mechanical strength, may be considered.

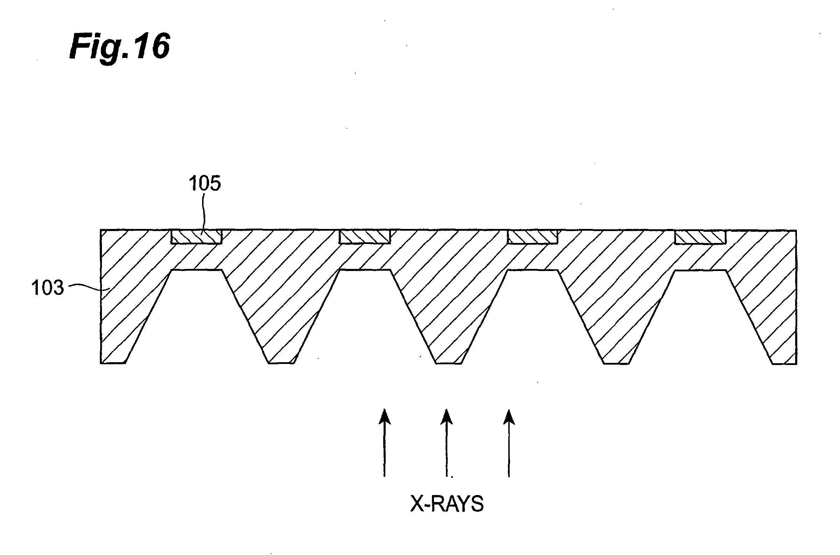

Fig. 16 is a sectional side view of such a photodiode array.

With this photodiode array, just the regions of an n-type layer 103, at which p-type diffused layers 105 are formed, are made thin from the side of a light-incident surface, and the regions that are not thinned are kept at the thickness of the original semiconductor substrate as frame parts to maintain the mechanical strength. With this photodiode array, recessed parts of the n-type substrate are formed from the side (back side), opposite the side at which pn junction parts are formed (front side), at positions corresponding to the respective pn junctions. That is, one recessed part is formed in correspondence to one pn junction pixel. A protruding part is thus remained between a pn junction pixel and an adjacent pn junction pixel.

However, when the above-described photodiode array is to be used as a radiation detector, the protruding parts of the photodiode array are attached by suction to a collet and flip-chip bonded to a mounting substrate, or a scintillator is put in contact with the protruding parts of the photodiode array.

In this process, the contacted surfaces of the protruding parts undergo mechanical damage, causing increases of the leakage current and the dark current due to the generation of carriers.

Since each protruding part is remained in the n-type layer, carriers are generated by light or radiation made incident on a protruding part itself and these can cause crosstalk by becoming incident on the pn junction pixels.

Also with this photodiode array, since each recessed part is formed with inclined surfaces of approximately 55° from the back side, the area of a bottom part of an recessed part decreases as the depth of the recessed part increases.

Thus if the widths of the frame parts are to be secured to obtain mechanical strength, an adequate photodetection part area cannot be obtained at the pn junction formation surface side and improvement of the rate of an opening cannot be achieved.
JP-A-10-223873 describes a semiconductor device with a single photodetecting section on one side of a substrate and a thinned section formed on the other side thereof.
JP-A-2001291892 describes a radiation detector with an N+ channel stop layer being formed as a lattice separating P+ diffusion layers on a rear surface of a semiconductor substrate. A scintillator is optically connected to the light incident surface of the semiconductor substrate.
US-A-4,814,847 discloses an InGaAs semiconductor device on a substrate with an etch stop layer on a first surface. Portions of the substrate are removed to provide a pattern of apertures. Dopant species are provided through a second surface of the substrate.

An object of the present invention is to provide a photodiode array and radiation detector, with which the rate of an opening and the detection sensitivity can be improved while securing mechanical strength.

### Disclosure of the invention

In order to resolve the above issues, this invention provides a photodiode array as defined in claim 1.

With this invention's photodiode array, recessed parts are formed at both sides of the semiconductor substrate.

Since the bottom part of each individual recessed part at one side opposes that of a recessed part at the opposite side, the distance between the light-incident surface and each pn junction formed at the bottom part of an opposite surface side recessed part is made small.

Also, since the parts besides the regions at which the pn junctions are formed can be kept at the original thickness of the substrate as frame parts, the mechanical strength of the semiconductor substrate can be maintained.

The recessed parts can be formed by thinning the semiconductor substrate from both sides.

In the thinning process, the area of the bottom part of a recessed part becomes smaller as the thinning progresses in the depth direction of the substrate.

Thus if the distance between pn junctions and the light-incident surface is the same, the area of each recessed part bottom surface can be made larger to thus increase the area of each photosensitive part and improve the rate of an opening when the recessed parts are formed at both sides than when recessed parts are formed from one side only.

In the case where the area of the bottom surface of each light-incident surface side recessed part is greater than the area of the bottom surface of each opposite surface side recessed part, the energy ray attenuation by the thick frame parts positioned in the periphery of the light-incident surface side recessed parts can be decreased to thereby improve the rate of an opening.

The arrangement may be characterized in that the pn junctions extend from the bottom parts of the opposite surface side recessed parts to opposite surface side frame parts that surround the opposite surface side recessed parts.

In this case, the influence of unnecessary carriers that are generated at slopes between the bottom parts and the frame parts can be restrained.

Furthermore, since p-type impurity diffused layers extend toward the opposite surface side frame parts, aluminum electrodes for connecting bump electrodes, formed on the opposite surface side frame parts, to the p-type impurity diffused layers do not need to be set along the inner surfaces of the opposite surface side recessed parts and facilitation of process is achieved.

High impurity concentration regions, in which an impurity is added at a high concentration, may be formed in the light-incident surface side frame parts that surround the light-incident surface side recessed parts.

In this case, since carriers that are generated by the incidence of light onto the light-incident surface side frame parts are annihilated by recombination in the high impurity concentration regions, the carriers that move to the pn junctions at the bottom parts of the opposite surface side recessed parts can be decreased to thereby reduce crosstalk among the respective photodiodes.

The light-incident surface side frame parts surrounding the light-incident surface side recessed parts may be formed in a lattice form as viewed from the direction of incidence of light.

In this case, since the coordinates of the positions of the respective light-incident surface side recessed parts are determined in matrix form, the positions of incidence of light can be discriminated readily.

With the present photodiode array, electrode pads, for taking out the outputs of the photodiodes formed of the pn junctions, may be equipped on the opposite surface side frame parts that surround the opposite surface side recessed parts.

In this case, the electrode pads, on the frame parts that correspond to being protruded parts with respect to the recessed parts, can be put in contact with a mounting wiring substrate in a mounting process to facilitate the wiring of the mounting wiring substrate.

The present photodiode array may be equipped with wiring electrodes, which pass along side surface parts of the opposite surface side recessed parts and electrically connect the photodiodes and the electrode pads.

That is, the wiring electrodes can connect the photodiodes and the electrode pads and enable application of bias voltages from the electrode pads to the photodiodes and the taking out of signals while being set at positions at which the wiring electrodes will not block the light that is made incident from the back side.

This invention's radiation detector comprises: the above-described photodiode array; and a scintillator, positioned in the front surface of incidence of light onto the photodiode array.

Since X-rays and other energy rays that are illuminated onto the scintillator are converted into visible light, this visible light can be detected by the photodiodes formed of pn junctions.

### Brief Description of the Drawings

Fig. 1 is a schematic plan view of a photodiode array of a first embodiment.

Fig. 2 is a sectional view of the photodiode array of the first embodiment.

Fig. 3 is a diagram for describing steps of manufacturing the photodiode array of the first embodiment.

Fig. 4 is a diagram for describing steps of manufacturing the photodiode array of the first embodiment.

Fig. 5 is a diagram for describing steps of manufacturing the photodiode array of the first embodiment.

Fig. 6 is a diagram for describing steps of manufacturing the photodiode array of the first embodiment.

Fig. 7 is a diagram for describing steps of manufacturing the photodiode array of the first embodiment.

Fig. 8 is a diagram for describing steps of manufacturing the photodiode array of the first embodiment.

Fig. 9 is a diagram for describing steps of manufacturing the photodiode array of the first embodiment.

Fig. 10 is a diagram for describing steps of manufacturing the photodiode array of the first embodiment.

Fig. 11 is a diagram for describing steps of manufacturing the photodiode array of the first embodiment.

Fig. 12 is a diagram for describing steps of manufacturing the photodiode array of the first embodiment.

Fig. 13A is a schematic sectional view of the photodiode array of a comparative example.

Fig. 13B is a schematic sectional view of a photodiode array of the first embodiment.

Fig. 14 is a sectional view of a radiation detector of a first embodiment.

Fig. 15 is a sectional view of a photodiode array of a prior art.

Fig. 16 is a schematic sectional view of a photodiode array of a comparative example.

Fig. 17 is a top view of a photodiode array of a second example which does not form a part of the present invention but is nevertheless described for the better understanding thereof.

Fig. 18 is a sectional side view of the photodiode array of the second example.

Fig. 19 is a diagram for describing steps of manufacturing the photodiode array of the second example.

Fig. 20 is a diagram for describing steps of manufacturing the photodiode array of the second example.

Fig. 21 is a diagram for describing steps of manufacturing the photodiode array of the second example.

Fig. 22 is a diagram for describing steps of manufacturing the photodiode array of the second example.

Fig. 23 is a diagram for describing steps of manufacturing the photodiode array of the second example.

Fig. 24 is a sectional side view of a photodiode array of a third example which does not form a part of the present invention but is nevertheless described for the better understanding thereof.

Fig. 25 is a sectional side view of a photodiode array of a fourth example which does not form a part of the present invention but is nevertheless described for the better understanding thereof.

Fig. 26 is a sectional side view of a photodiode array of a fifth example which does not form a part of the present invention but is nevertheless described for the better understanding thereof.

Fig. 27 is a sectional side view of a semiconductor substrate of an example which does not form a part of the present invention but is nevertheless described for the better understanding thereof.

Fig. 28 is a sectional side view of a radiation detector of the second example.

Fig. 29A is a top view showing the positional relationship of photosensitive pixel parts and bump electrodes.

Fig. 29B is a sectional view taken along XIV-XIV of the photodiode array shown in Fig. 29A.

Fig. 30A is a top view showing the positional relationship of photosensitive pixel parts and bump electrodes.

Fig. 30B is a sectional view taken along XV-XV of the photodiode array shown in Fig. 30A.

Fig. 31A is a top view showing the positional relationship of photosensitive pixel parts and bump electrodes.

Fig. 31B is a sectional view taken along XVI-XVI of the photodiode array shown in Fig. 31A.

Fig. 32A is an enlarged view of a chip end portion of a photodiode array shown in Fig. 32B.

Fig. 32B is a top view showing the positional relationship of photosensitive pixel parts and bump electrodes at the chip ends of a photodiode array of an example.

### Best Modes for Carrying Out the Invention

Radiation image pickup devices of embodiments shall now be described with reference to the drawings. In the description, the same symbols shall be used for elements that are the same or have the same functions and redundant description shall be omitted.

### (First Embodiment)

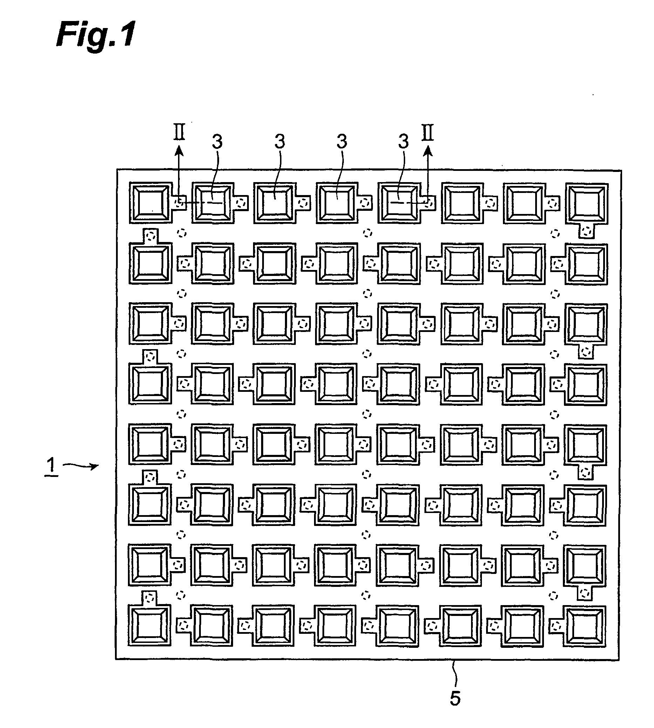

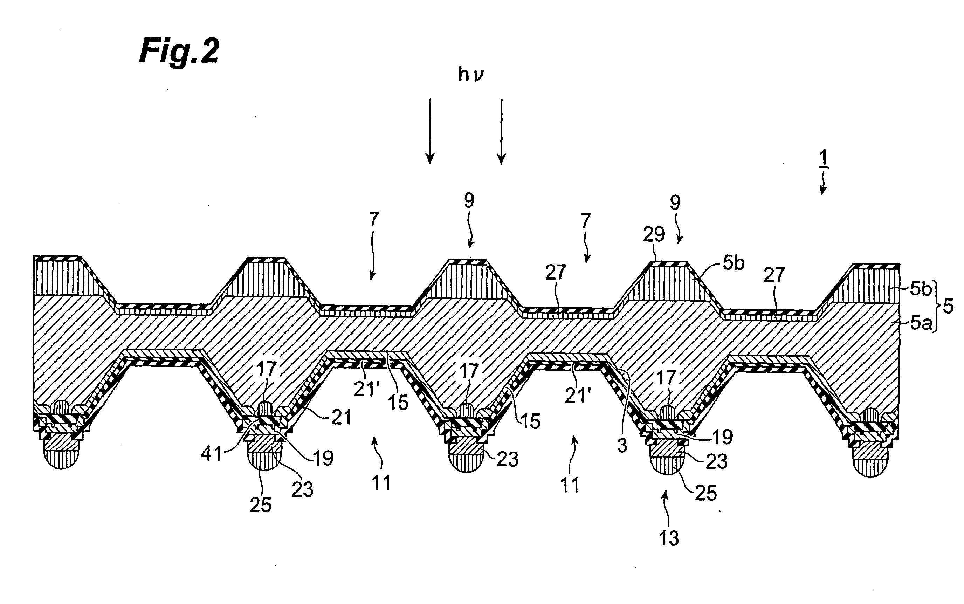

Fig. 1 is a plan view of a photodiode array, with which a photodiode array of an embodiment is viewed from a front side. Fig. 2 is a sectional view taken along arrows II-II of the photodiode array shown in Fig. 1. In the description that follows, a light-incident surface shall be referred to as the "back side" and the surface at the opposite side of the light-incident surface shall be referred to as the "front side."

As shown in Fig. 1, photodiode array 1 of the present embodiment has a plurality of pn junctions 3 aligned in a regular, two-dimensional manner in longitudinal and lateral directions, and each pn junction functions as a photosensitive pixel of a photodiode.

Photodiode array 1 is equipped with an n-type semiconductor substrate 5 formed of silicon (Si). n-type semiconductor substrate 5 has an n-type semiconductor layer 5a and an n⁺-type high impurity concentration layer 5b, which is formed by diffusion of an n-type impurity from the back side of the substrate.

The back side of n-type semiconductor substrate 5 is thinned by the forming of recessed parts, which form photosensitive pixels that are desired and are of rectangular pyramidal shape and of predetermined pitch, size, and depth, and these thin parts (recessed parts) make up light-incident surface side recessed parts 7 and are aligned two-dimensionally. Regions sandwiched between adjacent light-incident surface side recessed parts 7 make up light-incident surface side frame parts 9, which surround light-incident surface side recessed parts 7.

At the front side of n-type semiconductor substrate 5, positions corresponding to light-incident surface side recessed parts 7 are thinned to form opposite surface side recessed parts 11, which are aligned two-dimensionally. Regions sandwiched between adjacent opposite surface side recessed parts 11 make up opposite surface side frame parts 13, which surround opposite surface side recessed parts 11. Thin parts, which are thinned portions sandwiched by light-incident surface side recessed parts 7 and opposite surface side recessed parts 11 in the thickness direction, are thus aligned in array form in n-type semiconductor substrate 5.

Portions besides the thin parts of n-type semiconductor substrate 5 are arranged as thick plate parts by light-incident surface side frame parts 9 and opposite surface side frame parts 13. Since the thin parts are aligned two-dimensionally in matrix form at a predetermined pitch and predetermined size, the thick plate parts that serve as frame parts are formed in lattice form as viewed from the incidence direction of light. In this case, since the coordinates of the positions of the respective light-incident surface side recessed parts are determined in matrix form, the light-incident positions can be discriminated readily.

The inner side faces of each of opposite surface side recessed parts 11 and light-incident surface side recessed parts 7 respectively form an angle of substantially 55° with respect to the substrate surface and form a truncated rectangular pyramid. Opposite surface side recessed parts 11 and light-incident surface side recessed parts 7 may be similar or dissimilar in shape and may be equal or different in depth, and in the present example, the depth of each light-incident surface side recessed part 7 is shallower than the depth of each opposite surface side recessed part 11 so that the area of the bottom surface of each light-incident surface side recessed part 7 is greater than the area of the bottom surface of each opposite surface side recessed part 11. In this case, the amount of attenuation of energy rays by the thick plate frame parts positioned in the periphery of the respective light-incident surface side recessed parts 7 can be decreased and the rate of an opening can be improved.

The thickness of n-type semiconductor substrate is 100 to 350µm, and the impurity concentration of semiconductor layer 5a is 1 × 10¹² to 10¹⁵/cm³. Each light-incident surface side recessed part 7 has a size of 1mm × 1mm, an alignment pitch of 1.5mm in both the longitudinal and lateral directions, and a depth of approximately 50µm. Each opposite surface side recessed part 11 is smaller in size than an light-incident surface side recessed part 7 and is the same in alignment pitch as light-incident surface side recessed part 7.

At each opposite surface side recessed part 11, a p-type impurity diffused layer 15 extends continuously from opposite surface side frame parts 13 that surround opposite surface side recessed part 11 to the bottom surface of opposite surface side recessed part 11. A photosensitive pixel of a photodiode is arranged by a pn junction 3, formed across n-type semiconductor substrate 5 and p-type impurity diffused layer 15. Between adjacent p-type impurity diffused layers 15, an n⁺-type impurity region (separation layer) 17, which functions as a channel stopper that separates photodiodes from each other, is positioned.

The impurity concentration of p-type impurity diffused layer 15 is 1 × 10¹³ to 10²⁰/cm³ and the impurity concentration of n⁺-type impurity region (separation layer) 17 is 1 × 10¹³ to 10²⁰/cm³.

p-type impurity diffused layers 15 are put in contact with and connected to aluminum electrodes 19 (wiring electrodes), disposed on opposite surface side frame parts 13, and by the realization of electrical contact from the front side to the exterior via aluminum electrodes 19, under-bump metals (referred to hereinafter as "UBMs") 23, and bump electrodes 25 (electrode pads), the outputs of the photodiodes are arranged to be taken out to the exterior.

In the present embodiment, each p-type impurity diffused layer 15 is formed to be continuous to opposite surface side frame parts 13 and extend to the vicinity of a bump electrode 25, and each aluminum electrode 19 is formed on opposite surface side frame part 13 and electrically connects a p-type impurity diffused layer 15 with a UBM 23. In the case where each p-type impurity diffused layer 15 is formed on just the bottom part of an opposite surface side recessed part 11, the aluminum electrode is formed on a side face part at the inner side of opposite surface side recessed part 11 to connect p-type impurity diffused layer 15 with a bump electrode 25, disposed on opposite surface side frame part 13. Each UBM 23 passes through a passivation layer 21, formed of SiN or SiO₂, etc., in the thickness direction to electrically connect an aluminum electrode 19 with a bump electrode 25.

Also, though not illustrated, substrate electrodes may be lead out in likewise manner by forming contact holes in a separation layer (n⁺) and forming aluminum electrodes, UBMs, and bump electrodes on opposite surface side frame part 13.

At the back side of n-type semiconductor substrate 5, an accumulation layer 27 is formed continuously from light-incident surface side recessed parts 7 to light-incident surface side frame parts 9 so as to cover the entire back side. Accumulation layer 27 is made high in impurity concentration by diffusion of an n⁺-type impurity and is connected to high n⁺-type impurity concentration layers 5b at regions corresponding to light-incident surface side frame parts 9. Thus at each light-incident surface side frame part 9, a region, occupied by high n⁺-type impurity concentration layer 5b, to which an impurity is added at a high concentration, is formed.

Accumulation layer 27 serves the role of causing recombination of unnecessary carriers that are generated at the back side in order to realize high sensitivity and low dark current, and the role of guiding carriers in the direction of the pn junction by means of a built-in field resulting from a diffusion potential. The impurity concentration of accumulation layer 27 is 1 × 10¹⁵ to 10²⁰/cm³, and the thickness of accumulation layer 27 is 0.1µm to a few µm. A silicon oxide film 29 is furthermore provided on the back side of accumulation layer 27, and this functions as an antireflection film (AR coat).

As described above, with photodiode array 1 of the present embodiment, the regions corresponding to pn junctions 3 are thinned from both the back side and the front side and made thin in the thickness of the substrate. Meanwhile, the regions besides the thinned regions are left at the original thickness of the substrate and form thick plate frame parts that surround the recessed parts. High n⁺-type impurity concentration layers 5b, which are regions of high impurity concentration, are formed at light-incident surface side frame parts 9. The impurity concentration of high n⁺-type impurity concentration layers 5b is 1 × 10¹⁵ to 10²⁰/cm³.

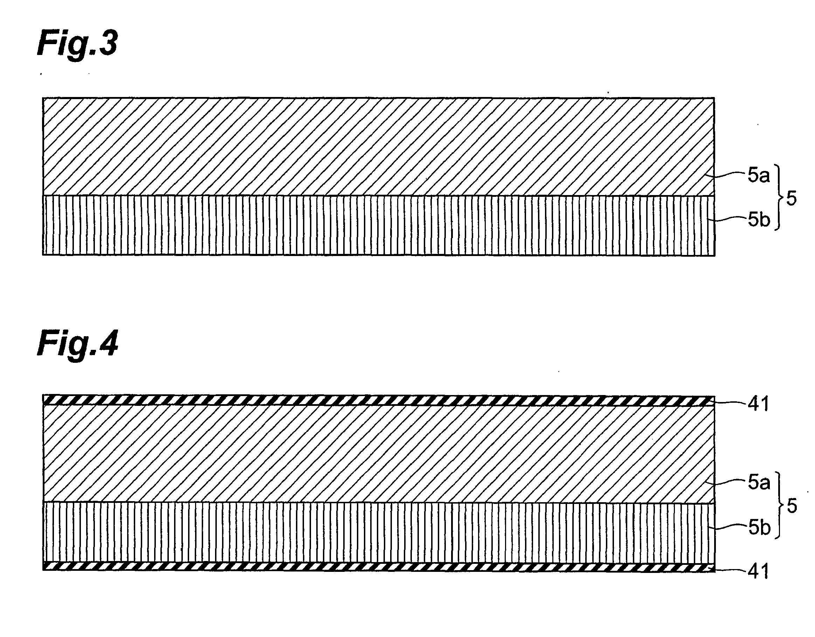

A method of manufacturing photodiode array 1 of the present embodiment shall now be described with reference to Fig. 3 to Fig. 12.

First, n-type silicon substrate 5 with a (100) crystal plane and a thickness of approximately 150µm to 500µm is prepared. High n⁺-type impurity concentration layer 5b is then formed by thermal diffusion on the back side of n-type silicon substrate 5, thereby preparing a substrate with the two-layer structure of n-type substrate layer 5a and high n⁺-type impurity concentration layer 5b (see Fig. 3).

The front and back sides of the substrate are then subject to thermal oxidation to form silicon thermal oxide films 41 (see Fig. 4). Silicon thermal oxide films 41 are used as masks for the doping of an n-type impurity at high concentration in subsequent steps.

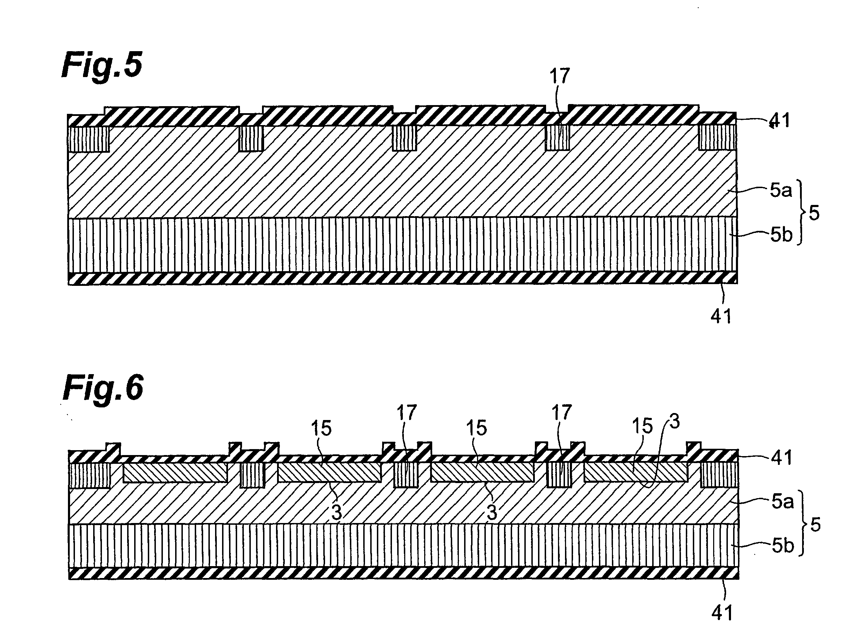

Separation layers 17 are then formed. By means of photolithography and an etching solution, silicon thermal oxide film 41 is opened at planned positions of separation layers 17. Then using silicon thermal oxide film 41 as a mask, phosphorus is doped into the substrate to form separation layers 17 and then the substrate is thermally oxidized to close the above-mentioned openings (see Fig. 5).

The silicon thermal oxide film at regions between separation layers 17 are then opened by means of photolithography and an etching solution. Then using the thermal oxide film as a mask, boron is doped into the substrate to form p-type impurity diffused layers 15 and then the above-mentioned openings are closed by thermal oxidation. A plurality of pn junctions 3, which are separated by separation layers 17, are thereby formed in matrix form, and these pn junctions 3 become portions corresponding to photosensitive pixels (see Fig. 6). The pn junctions that make up the photodiodes are formed across p-type impurity diffused layers 15 and n-type semiconductor layer 5a.

The back side is then subject to chemomechanical polishing in order to adjust the photosensitive regions of the substrate to a desired thickness.

Silicon nitride (SiN) films 43 are formed on the front side and back side of the substrate by plasma CVD (chemical vapor deposition) or by LP-CVD (low-pressure chemical vapor deposition), and silicon nitride films 43 and silicon thermal oxide films 41, at portions corresponding to opposite surface side recessed parts 11 and light-incident surface side recessed parts 7, are removed by etching.

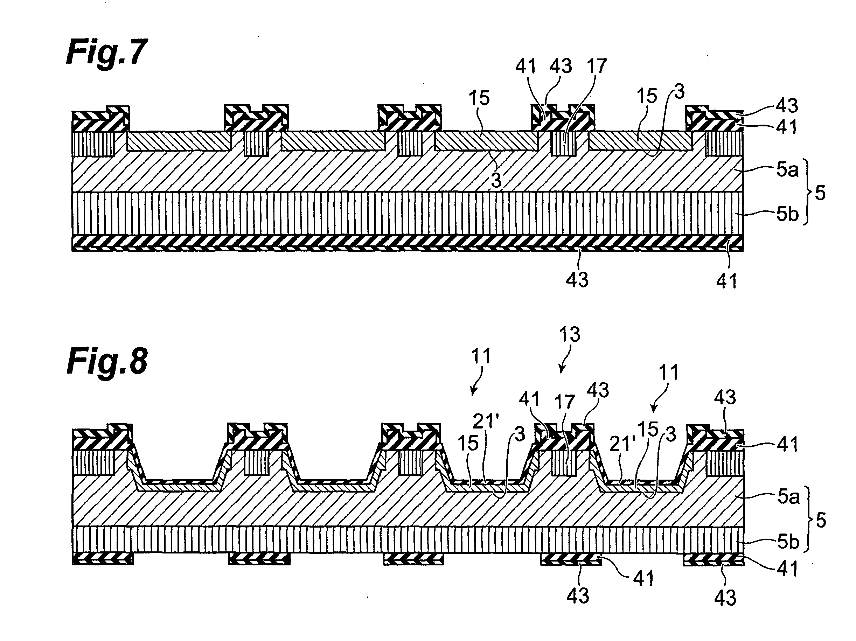

That is, first, an SiN film 43 is formed on the opposite surface, and using a photoresist, which has been patterned by photolithography, as a mask, the regions above pn junctions 3 are removed by etching to expose the surface of p-type impurity diffused layers 15 (see Fig. 7).

The opposite surface side of the substrate is then etched anisotropically by alkaline etching method (using a potassium hydroxide solution or TMAH, etc.). Opposite surface side recessed parts 11, corresponding to photosensitive pixels, are thus formed, and the portions that were not etched become opposite surface side frame parts 13 that surround the respective opposite surface side recessed parts 11. This etching is performed to a depth of at least 2µm or more, a p-type impurity is then diffused or ion-implanted from the exposed surfaces at the opposite surface side to form p-type impurity layers 15 inside the recessed parts as well, and then thermal oxide films 21' that cover the inner surfaces of the recessed parts are formed.

In likewise manner, SiN film 43 and silicon thermal oxide film 41, at the back side of the substrate that serves as the light-incident side, are opened at positions opposing opposite surface side recessed parts 11, and using the films as masks (see Fig. 8), anisotropic etching is applied to the substrate to form light-incident surface side recessed parts 7, at positions corresponding to the respective opposite surface side recessed parts 11, and light-incident surface side frame parts 9, which surround the respective light-incident surface side recessed parts 7. The etching is performed to a depth of at least 2µm or more and so that the remaining substrate thickness will be at least such that pn junctions 3 at the front side will not be in competition with accumulation layer 27 of the back side, which is to be formed subsequently.

After removing silicon nitride films 43 at both sides of the substrate, an n-type ion species (phosphorus or arsenic) is doped into the recessed parts of the back side to form accumulation layers 27 with an impurity concentration of 10¹⁵ to 10²⁰/cm³. Thereafter, thermal oxide film 45 is formed. High n⁺-type impurity concentration layer 5b is thereby unified with accumulation layers 27. The thickness of accumulation layers 27 is set to a thickness that will not reach pn junctions 3 at the front side.

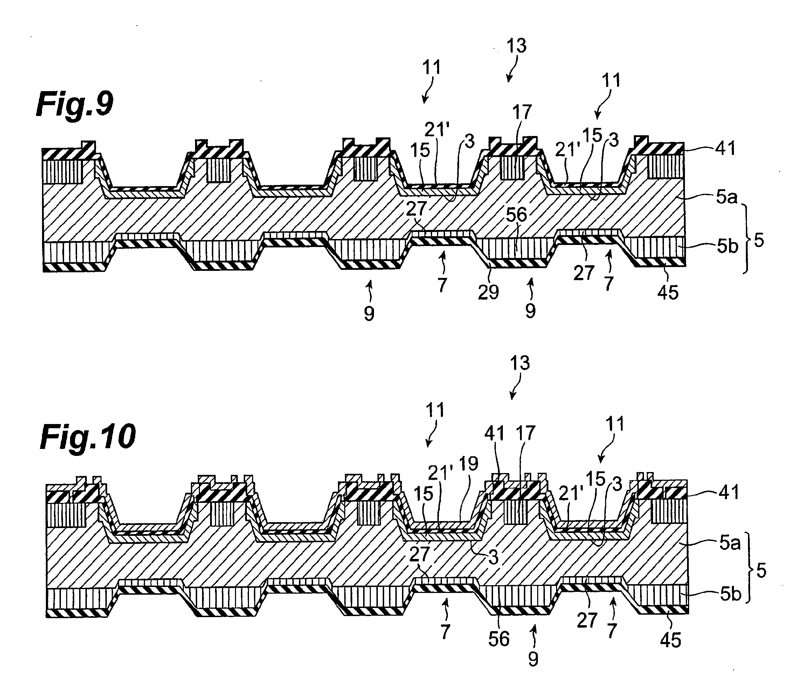

AR coat 29, for providing the desired spectroscopic characteristics, is then formed on the back side (see Fig. 9). The above-mentioned thermal oxide film 45 may be used as it is as AR coat 29 or the buffer oxide film may be removed and the film thickness may be adjusted by performing thermal oxidation again or performing additional thermal oxidation to provide AR coat 29. AR coat 29 may also be formed as a composite film or laminated film of the thermal oxide film with SiN and other optical thin films, etc.

Thereafter, contact holes for p-type impurity diffused layers 15 are formed in thermal oxide films 21' and aluminum electrodes 19 are formed so as to be at least embedded inside the contact holes (see Fig. 10). Passivation layer 21 is then deposited and patterned with portions at which bump electrodes are to be formed on aluminum electrodes 19 being opened. Aluminum electrodes 19 are formed so as to electrically connect p-type impurity diffused layers 15 and the bump electrodes.

Also, though not illustrated, bump electrodes for substrate electrodes may be provided across separation layers 17 in likewise manner.

As passivation layer 21, a layer of SiN, SiO₂, PSG, PSAG, or SiON, formed by plasma CVD, or a polyimide resin, acrylic resin, epoxy resin, urethane resin, or composite material containing such materials may be used.

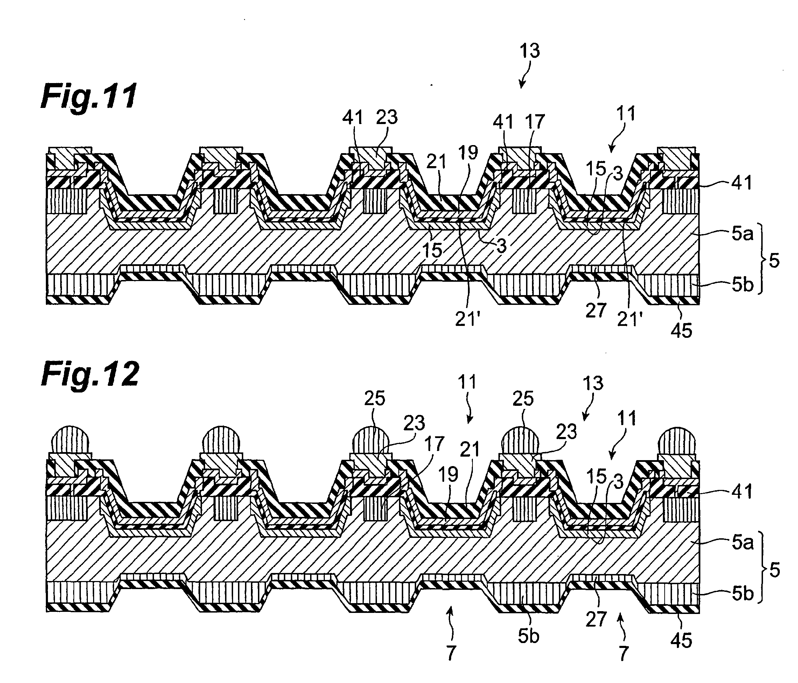

In the case where solder is to be used as the bump electrodes, since solder is poor in wetting property with respect to aluminum, UBMs 23, for intermediating between aluminum and solder bump electrodes 25, are formed inside the openings of passivation film 21 (see Fig. 11) and solder bump electrodes 25 are furthermore formed overlappingly on UBMs 23 (see Fig. 12). As UBMs 23, Ni-Au may be formed by electroless plating, or Ti-Pt-Au or Cr-Au may be formed by a lift-off method.

Solder bumps may be formed by forming solder on predetermined UBM portions by solder ball mounting or printing and then carrying out reflowing. The bumps are not limited to solder and may be metal-containing conductive bumps, such as gold bumps, nickel bumps, copper bumps, conductive resin bumps, etc.

With the above-described photodiode array 1, since pn junctions 3 are formed at regions at which the semiconductor substrate has been thinned from both sides, the distance between pn junctions 3 and the light-incident surface can be made small while leaving the regions besides the regions at which pn junctions 3 are formed at the original thickness of the substrate to thereby enable the mechanical strength of the substrate as a whole to be maintained. Also, with the above-described photodiode array 1, recessed parts are formed by thinning the substrate from both sides.

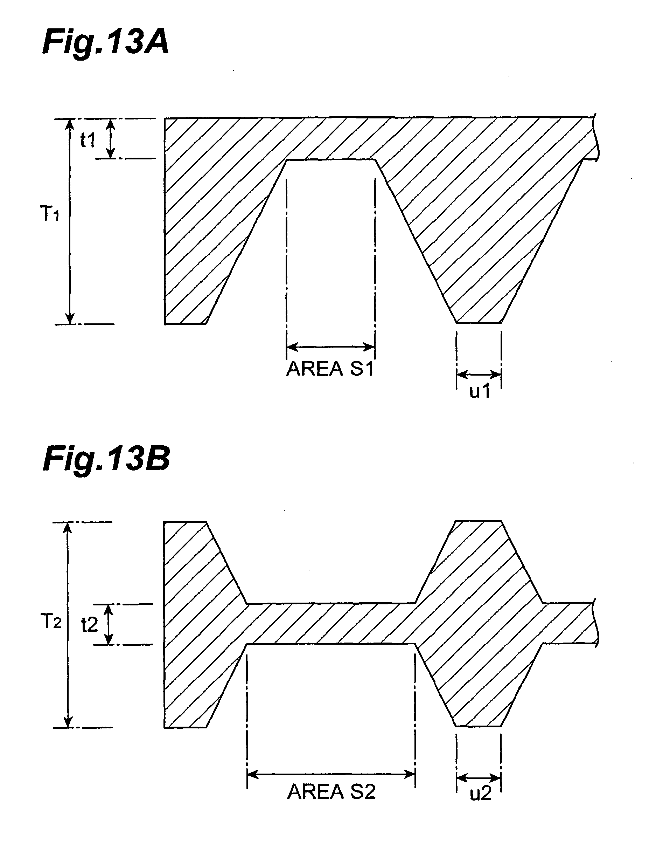

Fig. 13A schematically shows the cross-sectional shape of a photodiode array, which has been thinned from only one side of a substrate, and Fig. 13B shows the cross-sectional shape of a photodiode array of the present embodiment, which has been thinned from both sides of a substrate. It can be understood that though both photodiode arrays are equal in substrate thickness (T1, T2), photodiode region thickness (t1, t2), and frame part width (u1, u2), the photodiode array of the present embodiment is greater in the area of the bottom surface of the recessed part (S1, S2). Thus with photodiode array 1 of the present embodiment, even if the distance between pn junctions 3 and the light-incident surface and the frame part width are the same as in the case where recessed parts are formed from just one side, since the area of the bottom surface of each recessed part becomes larger when etching is performed from both sides than when recessed parts are formed from one side only, a large photosensitive part area can be secured and the rate of an opening can be improved.

With the above-described photodiode array 1, in the process of forming opposite surface side recessed parts 11, the edge parts between the inner side surfaces and opposite surface side frame parts 13 tend to become damaged or receive stress readily and thus tend to give rise to unnecessary carriers. However, since p-type impurity diffused layers 15 are formed continuously from opposite surface side frame parts 13 to the bottom surfaces of the corresponding opposite surface side recessed parts 11 via the inner side surfaces of opposite surface side recessed parts 11, the edge parts will be formed of p-type impurity diffused layers 15 and thus the effects of unnecessary carriers generated at the edge parts can be restrained and reduction of the dark current and crosstalk can be realized.

With the above-described photodiode array 1, the area of the bottom surface of each light-incident surface side recessed part 7 is made larger than the area of each opposite surface side recessed part 11. Carriers, which have been generated by light that has been made incident on light-incident surface side frame parts 9, can thus be restrained from moving to the pn junctions at the bottom surfaces of the recessed parts and reduction of the dark current and crosstalk can thus be realized.

With the above-described photodiode array 1, since high n⁺-type impurity concentration layers 5b, which are regions of high n-type impurity concentration, exist at light-incident surface side frame parts 9 and light-incident surface side recessed parts 7, carriers that are generated by the incidence of light onto light-incident surface side frame parts 9 are recombined and annihilated at the high n⁺-type impurity concentration layers 5b and are made less likely to move to p-type impurity diffused layers 15. The thickness of high n⁺-type impurity concentration layers 5b can be set longer than the carrier diffusion length. Crosstalk between photodiodes, which occurs as a result of incidence of light on light-incident surface side frame parts 9 that correspond to being channel intervals for currents flowing through the photodiodes, can thus be reduced.

Also, since by using frame parts (protruding parts) 9, the unnecessary carriers (carriers for which the travel distance to a carrier output electrode is long) that are generated at frame parts 9 are trapped by high n⁺-type impurity concentration layers (dead region) 5b, the effects of preventing the skewing of the photodetection waveform and quickening the response speed are also provided. As such a dead region to be provided in frame parts 9, an insulating layer, etc., may also be employed.

With the above-described photodiode array 1, since bump electrodes 25 are formed on opposite surface side frame parts 13, the electrodes can be put in contact with a mounting wiring substrate at opposite surface side frame parts 13 in the process of mounting and the wiring of the mounting wiring substrate can thus be prevented from becoming complicated.

With the above-described photodiode array 1, since aluminum electrodes 19 are formed at inner side surfaces of opposite surface side recessed parts 11, even in cases where the photodiodes are formed at just the bottom parts of opposite surface side recessed parts 11, contact of p-type impurity diffused layers 15 and opposite surface side frame parts 13 can be achieved via aluminum electrodes 19 and bump electrodes 25 can be formed on opposite surface side frame parts 13.

Though with the photodiode array of the present embodiment, high n⁺-type impurity concentration layers 5b are formed by thermal diffusion at the back side of n-type silicon substrate 5 to prepare semiconductor substrate 5 with a two-layer structure having n-type semiconductor layer 5a and high n⁺-type impurity concentration layers 5b, an insulating film may be disposed between the above-mentioned two layers or a semiconductor layer of crossing crystal orientation may be disposed at the interface of the above-mentioned two layers and made to serve as an etching stop layer in the process of forming the thin parts to thereby facilitate control of the etching step.

An embodiment of this invention's radiation detector shall now be described.

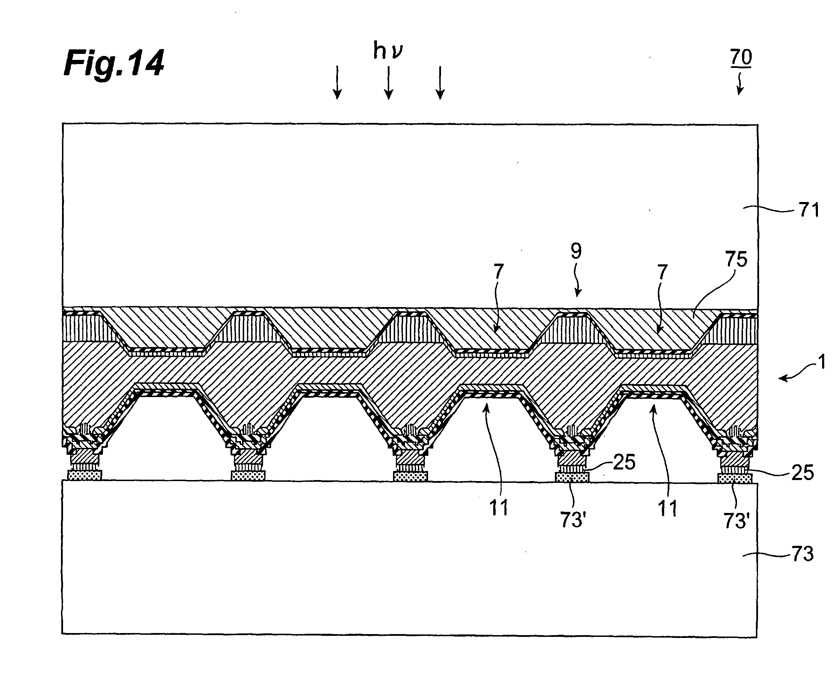

Fig. 14 is a sectional side view of radiation detector 70 of this embodiment. This radiation detector 70 is equipped with: a scintillator 71, which generates fluorescence when X-rays or other radiation hv are or is made incident and emits this fluorescence from its light exit surface; the above-described photodiode array 1, onto which the light emitted from scintillator 71 is made incident and which converts this light into electrical signals; and a mounting wiring substrate 73.

Scintillator 71 is installed at the back side of photodiode array 1 and is put in contact with photodiode array 1 at light-incident surface side frame parts 9. Though gaps thus exist between scintillator 71 and light-incident surface side recessed parts 7, these gaps are filled with a coupling resin 75, having a refractive index adequate for transmission of the fluorescence from scintillator 71, and light emitted from scintillator 71 is thus arranged to be made incident onto photodiode array 1 efficiently.

Wirings 73' on mounting wiring substrate 73 are disposed at the front side of photodiode array 1 and are electrically connected via bump electrodes 25 to the respective photodiodes making up photodiode array 1. With the present embodiment, flip-chip mounting is employed, and as bump electrodes 25, metal-containing conductive bumps, such as solder bumps, gold bumps, nickel bumps, copper bumps, conductive resin bumps, etc., are used.

Also as the bonding method, forms of direct bonding, filling with an underfill resin upon performing direct bonding, anisotropic conductive film (ACF) methods, anisotropic conductive paste methods (ACP), non-conductive paste (NCP) methods, etc., may be employed.

In the process of bonding photodiode array 1 onto mounting wiring substrate 73, light-incident surface side frame parts 9 are attached by suction to a suction collet, and light-incident surface side frame parts 9 may sustain mechanical damage in this process. Carriers that give rise to dark current and noise may thus be generated from the defective parts. Also, in installing scintillator 71 onto the back side of photodiode array 1, scintillator 71 is put in contact with light-incident surface side frame parts 9, and light-incident surface side frame parts 9 may sustain mechanical damage in this process. Unnecessary carriers may be generated in this case as well.

However, with the above-described radiation detector, since the photodiode array of the above-described invention is used and light-incident surface side frame parts 9 are provided with n⁺-type diffused layers 5b of high impurity concentration, the generated carriers can be made to recombine and the dark current and noise can thus be reduced.

Also with the above-described radiation detector, since light-incident surface side frame parts 9 are positioned between the photosensitive pixels of photodiode array 1, the incident light can be separated according to pixel. Furthermore, since light-incident surface side frame parts 9 are provided with n⁺-type diffused layers 5b of high impurity concentration, carriers, which are generated by light made incident on light-incident surface side frame parts 9, undergo recombination. Light that has become incident between photosensitive pixels, that is, on a frame part 9 is thus restrained from becoming taken out as a signal. Thus with the above-described radiation detector, crosstalk among the photosensitive pixels can be improved.

If with a radiation detector, a photodiode array without recesses or protrusions on the back side is to be used, the suction collet will come in direct contact with the photosensitive pixels in the process of bonding the photodiode array onto mounting wiring substrate 73. Since the scintillator will likewise contact the photosensitive pixels directly in the process of mounting the scintillator, the photosensitive pixels tend to become flawed and pixel defects are caused readily. However, with the above-described radiation detector, since the photosensitive pixel parts are positioned in opposite surface side recessed parts 11 and the photosensitive pixels are not contacted directly in the mounting steps, mechanical damage is unlikely to be incurred and photosensitive pixel defects can be prevented.

As described above, with this invention's photodiode array and radiation detector, the detection sensitivity can be improved and the rate of an opening can be improved while securing mechanical strength.

A photodiode array, with which recessed and protruding parts are formed on one side of substrate, shall now be described. This and each of the subsequent examples does not form a part of the present invention but is nonetheless described so that the skilled reader might gain a better understanding thereof.

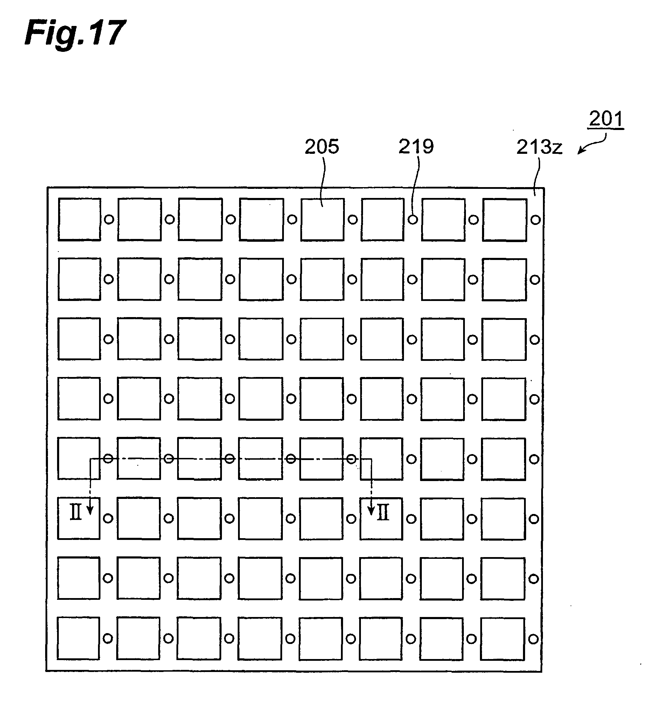

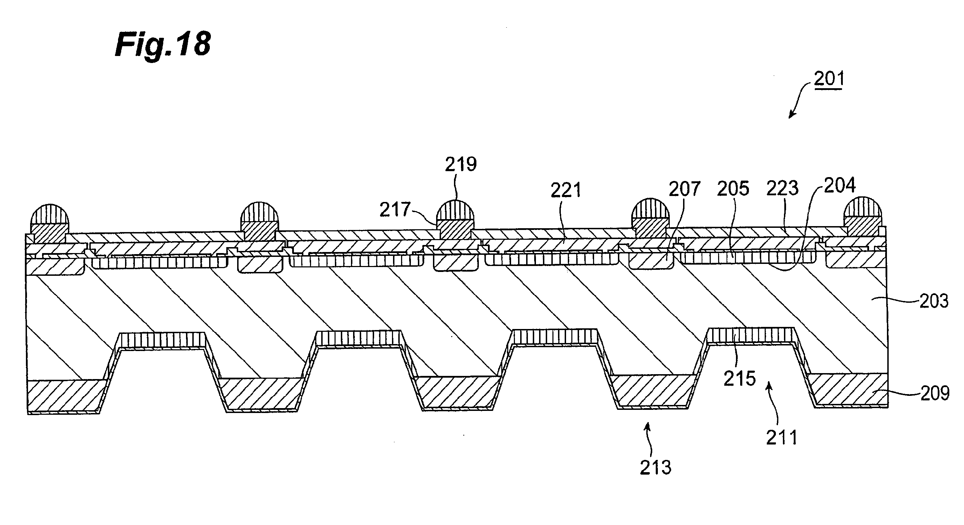

Fig. 17 is a plan view of a photodiode array of a second example and Fig. 18 is a sectional view taken along II-II of Fig. 17.

In the following description, the surface of the substrate at which pn junctions 204 are formed shall be referred to as the "front side," and the light-incident surface (recessed part side) shall be referred to as the "back side."

As shown in Fig. 17, with photodiode array 201 of the present example, a plurality of pn junctions are aligned in a regular manner in the longitudinal and lateral directions, and each one of the pn junctions functions as a single photosensitive pixel of the photodiode array. Photodiode array 201 has an n-type silicon substrate 203 with a thickness of 50 to 600µm and an impurity concentration of 1 × 10¹² to 10¹⁵/cm³, and a plurality of p-type impurity diffused layers 205 with a size of 500µm × 500µm and an impurity concentration of 1 × 10¹⁵ to 10²⁰/cm³ are positioned at a pitch of approximately 600µm. The above-mentioned photosensitive pixels are formed by pn junctions formed across n-type silicon substrate 203 and the plurality of p-type impurity diffused layers 205. n⁺-type impurity regions (separation layers) 207, which separate the photodiodes, are positioned between p-type impurity diffused layers 205.

At the back side of n-type silicon substrate 203, n⁺-type impurity regions 209, with a thickness of approximately 2µm to 200µm and an impurity concentration of 1 × 10¹⁵ to 10²⁰/cm³, are positioned at regions not corresponding to p-type impurity diffused layers 205. Thus with this invention's photodiode array, the regions at which the p-type impurity layers are formed have recessed parts 211 formed therein by being thinned to a thickness, for example, of approximately 50µm to 300µm, and protruding parts (frame parts) 213 are formed at the thick back side of approximately 150 to 500µm thickness at the other regions. The thick parts are formed at regions at which the pn junctions are not formed, that is, between the respective photodiodes, and are arranged from n⁺-type impurity diffused layers 209 of 2µm to 200µm thickness and n-type silicon substrate 203 of approximately 50µm to 300µm thickness. One recessed part 211 is thus provided for one pn junction (photosensitive pixel).

At the back side of each thinned n-type substrate (photodiode-corresponding region), an n⁺ impurity diffused layer is formed over the entire surface at a thickness of 0.1 to a few µm. Each n⁺ impurity diffused layer 215 has an accumulation function of sending signal carriers, generated in the vicinity of the n-type silicon substrate surface by the incidence of light (especially of short wavelength) from the back side, to the interior of the substrate. Also, a passivation film 223, formed of SiN or SiO₂ or polyimide, etc., is formed on the front side of the substrate.

At the front side of each p-type impurity diffused layer 205, an aluminum wiring electrode 221, which is slightly larger than p-type impurity diffused layer 205, is installed and put in electrical contact with p-type impurity diffused layer 205. At each position of the front side that corresponds to protrusion 213, a solder bump electrode 219 is installed through passivation layer 223 and via an under-bump metal (UBM) 217, which is formed of Ni-Au and contacts an aluminum wiring electrode 221, and in the process of mounting photodiode array 201, electrical contact from the front side to p-type impurity diffused layers 205 is achieved via bump electrodes 219, UBM 217, and aluminum wiring electrodes 221.

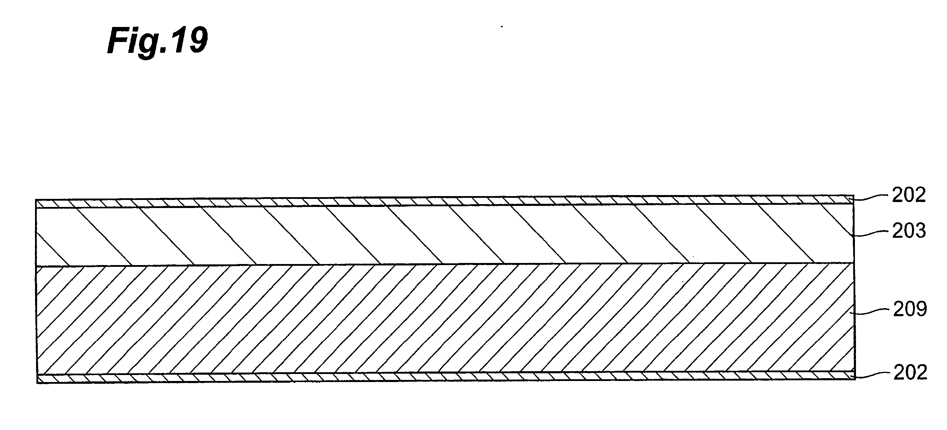

A method of manufacturing the photodiode array of the present example shall now be described based on Fig. 19 to Fig. 23. First, n-type silicon substrate 203 with a (100) crystal plane and a thickness of approximately 50µm to 600µm is prepared. By then forming uniform n⁺-type diffused layer 209 with a depth 150 to 250µm by thermal diffusion at the back side of the substrate, a substrate, with the two-layer structure of the n-type layer and the n⁺-type layer, is prepared. The front side and back side of this substrate are then subject to thermal oxidation to form SiO₂ thermal oxide films 202 (see Fig. 19). SiO₂ thermal oxide films 202 are used as n⁺ thermal diffusion masks in subsequent steps.

Then at positions at which the separation layers between adjacent photodiodes are planned to be formed, SiO₂ thermal oxide film 202 is opened by a photoetching process and separation layers 207 are formed by doping phosphorus and then carrying out thermal oxidation.

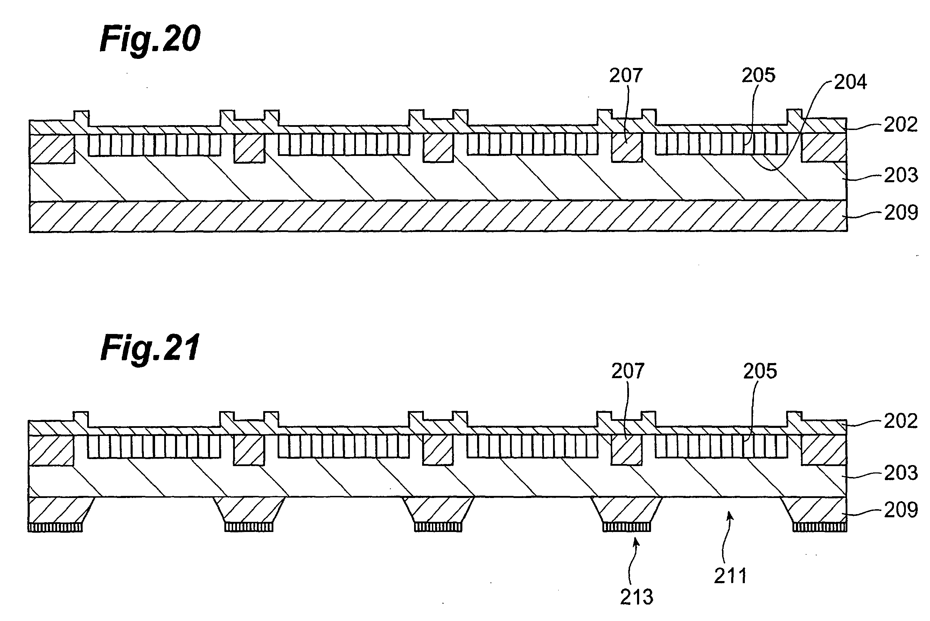

p-type impurity layers 205 are then diffused to form pn junctions 204 at predetermined regions of the front side of n-type silicon substrate 203. At the positions at which the photosensitive pixels are to be formed, the SiO₂ thermal oxide film is first opened by a photoetching process, boron is doped, and thermal oxidation is carried out. A plurality of pn junctions 204 are thus formed at the other side of the n-type substrate, and these pn junction regions 204 become the portions corresponding to the photosensitive pixels. The photodiode array, comprising photodiodes, is thus formed (see Fig. 20).

The back side is polished as necessary in order to adjust the substrate thickness. A silicon nitride film (SiN) is formed on the back side by plasma CVD or LP-CVD, and the SiN at portions corresponding to the photosensitive pixels is removed by etching. The back side is then etched anisotropically by alkaline etching method (using a potassium hydroxide solution or TMAH, etc.) (see Fig. 21). In this process, portions besides the portions corresponding to the respective photosensitive elements are not thinned but are left with n⁺ diffused layers 209 and arranged as thick parts. Recessed parts 211 are thus formed at portions corresponding to the photosensitive pixels and protruding parts 213 are formed between adjacent photosensitive pixels. The etching is performed to a depth of at least 2µm or more and is performed to the vicinities of the interfaces of n⁺-layers 209 and n-layer 203 of the substrate. That is, n⁺-layer 209 may be left slightly or n-layer 203 may be exposed by the etching.

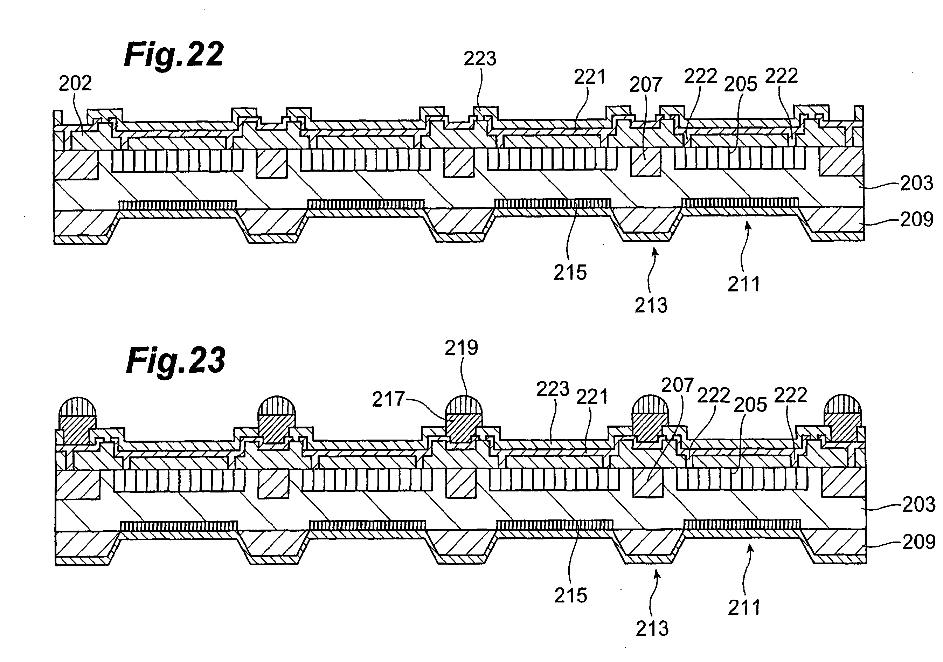

After removing the etching mask (SiN), thermal oxidation (buffer oxidation) is carried out and an n-type ion species (for example, phosphorus or arsenic) is doped into the back side to form accumulation layers 215 with an impurity concentration of 10¹⁵ to 10²⁰/cm³ (see Fig. 22). Thermal oxidation is then carried out. Accumulation layers 215 are formed so that its thickness does not reach p⁺ layers 205 at the front side of the substrate. Though an AR coat is then provided on the back side to obtain the desired spectroscopic characteristics, the above-mentioned oxide film may be adjusted in film thickness and thereby formed into the AR coat. Or, an AR coat may be formed by a composite film of the thermal oxide film and SiN or other optical thin film.

Thereafter, contact holes 222 for the p⁺ layers and the n⁺ layers are formed at the front side and aluminum wiring electrodes 221 are formed (see Fig. 22). Passivation film 223 is then deposited over the entire surface so as to cover aluminum wiring electrodes 221. The width of each aluminum wiring electrode 221 is preferably made slightly greater than the width of the p⁺ layer and the n⁺ region. The withstand voltage characteristics in cases of bias application are thereby improved and the forming of an inversion layer due to surface damage can be prevented. Passivation film 223 is then patterned in a state wherein the portions at which bump electrodes are to be formed on the aluminum wiring electrodes are opened (see Fig. 22). As passivation layer 223, a layer of SiN, SiO₂, BPSG, PSG, or SiON, formed by plasma CVD, or a polyimide, acrylic, epoxy, urethane, or composite material containing such materials may be used.

In the case where solder is to be used as the bump electrodes, since solder is poor in wetting property with respect to aluminum, intermediary metal layers 217 (under-bump metal, UBM), for intermediating between aluminum and solder bump electrodes 219, are formed and solder bump electrodes 219 are furthermore formed overlappingly (see Fig. 23). As the UBMs, Ni-Au may be formed by electroless plating, or Ti-Pt-Au or Cr-Au may be formed by a lift-off method. Solder bumps may be formed by forming solder on predetermined UBM portions by solder ball mounting or printing and then carrying out reflowing. The bumps are not limited to solder and may be metal-containing conductive bumps, such as gold bumps, nickel bumps, copper bumps, conductive resin bumps, etc.

Here, since n⁺-type diffused layers 209, which make up protruding parts 213 between the photodiodes, are higher in n-type impurity concentration than the n-type substrate, even though carriers are generated by the incidence of light onto n⁺-type diffused layers 209 of protruding parts 213, the generated carriers recombine and are thereby annihilated in n⁺-type diffused layers 209 of protruding parts 213 and thus do not move into n-type substrate 203 in the above-described photodiode array. Crosstalk among photodiodes, which occurs as a result of light becoming incident on intervals between photodiode channels, can thus be reduced. At the same time, by making the intervals between the photosensitive pixels thick, the mechanical strength of the substrate as a whole can be maintained and the occurrence of warping, distortion, etc., of the substrate itself can be restrained. The increase of dark current, resulting from mechanical damage sustained in the process of attaching protruding parts 213 of the photodiode array by suction to a collet and performing flip-chip bonding onto a mounting substrate or in the process of mounting a scintillator onto protruding parts 213 of the photodiode array, can be restrained.

Also, thermal diffusion is used in forming the n⁺ layer of the substrate. Thus unlike cases where the n⁺ layer is formed by another method (for example, by adhesion of substrates, etc.), the impurity concentration is made higher the closer to the back side of the substrate and the impurity concentration is made high at protruding parts 213. The carrier recombination and annihilation effect is thus improved and the effect of reducing the dark current, leak current, and crosstalk is also improved.

### (Third example)

A photodiode array of a third example of this invention shall now be described.

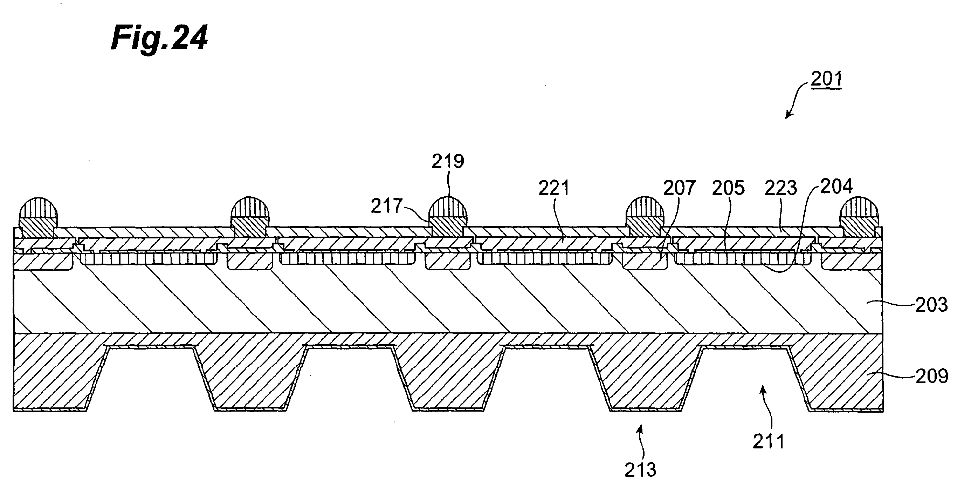

Fig. 24 is a sectional side view of the photodiode array of this example. In regard to the differences in arrangement with respect to the photodiode array of the second example, whereas with the photodiode array of the second example, n⁺-type accumulation layers 215 are formed inside n-type substrate 203, with the photodiode array of the present embodiment, a few µm of n⁺-type impurity diffused layer 209 is left and made to function as an accumulation layer (see Fig. 24). The function of the accumulation layer does not differ from the function described with the second example.

The above-mentioned difference results from a difference in the method of manufacturing the photodiode array. In the process of performing etching to form recessed parts at portions corresponding to the photosensitive pixels, whereas etching is performed until n-layer 203 is reached in the first embodiment, with the present example, the etching is stopped at approximately 0.1 to a few µm prior to reaching the interface between the n⁺-layer and the n-layer.

Since with the above-described photodiode array, the n⁺-type impurity diffused layer of a few µm thickness that is left without being etched functions as the accumulation layer as well, the accumulation layer does not have to be formed by performing ion implantation anew as in the first embodiment and such a step can be omitted. Besides the above, the arrangement and manufacturing method are exactly the same as those of the photodiode array of the first embodiment.

Though with the above-described photodiodes of the second and third examples, n⁺ diffused layer 209 is formed on the back side of n-type silicon substrate 203 to form an n-n⁺ substrate, the following modifications can be considered in regard to the step of preparing the n-n⁺ substrate.

An n-n⁺ substrate can be formed by preparing an n⁺-type substrate and epitaxially growing an n-layer at a (100) or (110) crystal plane on the front side of the substrate. Oppositely, an n-n⁺ substrate can be formed by preparing an n-type substrate and epitaxially growing an n'-layer at a (100) or (110) crystal plane on the front side of the substrate. These methods provide the advantage that the impurity concentration profile becomes step-like and flat etching is enabled in the process of performing etching to form the recessed parts.

Also, since the n⁺-substrate or n⁺-epitaxial growth layer, with which an impurity is added at high concentration, can be made uniform in concentration in the depth direction, the advantage of enabling carriers, generated by light with the range between short wavelength and long wavelength made incident on the protruding parts, to become recombined and thereby reducing crosstalk is provided.

Also, in the case where the impurity of the first conductive type is a p-type impurity and a semiconductor layer, with which the concentration of this impurity is 1 × 10¹⁷/cm³ or less, is formed by crystal growth, flat recessed parts can be formed by performing alkaline etching until the above-mentioned semiconductor interface is exposed and thereafter performing etching using a mixed solution of hydrofluoric acid, nitric acid, and acetic acid since the etching stops at the interface.

An n-n⁺ substrate can also be formed by preparing an n-type substrate with a (100) or (110) crystal plane and adhering an n⁺-type substrate to the back side upon matching the crystal plane with the above-mentioned n-type substrate. This method provides the advantage that the impurity concentration profile in the n-layer and the n⁺-layer becomes step-like and flat etching is enabled in the process of performing etching to form the recessed parts.

Also, since the n⁺-substrate, with which an impurity is added at high concentration, can be made uniform in concentration in the depth direction, the advantage of enabling carriers, generated by light with the range between short wavelength and long wavelength made incident on the protruding parts, to become recombined and thereby reducing crosstalk is provided.

Also, in the case where the impurity of the first conductive type is a p-type impurity and a semiconductor substrate, with which the concentration of this impurity is 1 × 10¹⁷/cm³ or less, is adhered to form the n-n⁺ substrate, flat recessed parts can be formed by performing alkaline etching until the above-mentioned semiconductor interface is exposed and thereafter performing etching using a mixed solution of hydrofluoric acid, nitric acid, and acetic acid since the etching stops at the interface.

An n-n⁺ substrate can also be formed by preparing an n-type substrate with a (111) crystal plane and adhering an n⁺-type substrate with a (100) or (110) crystal plane to the back side. By doing so, since in performing alkaline etching from the n⁺-layer side, the etching rate of the (111) plane will be extremely slow in comparison to the (100) or (110) plane, the etching can be stopped substantially at the point at which the n-layer is reached, thus providing the advantage that control of etching is facilitated.

### (Fourth example)

A photodiode array of a fourth example of this invention shall now be described.

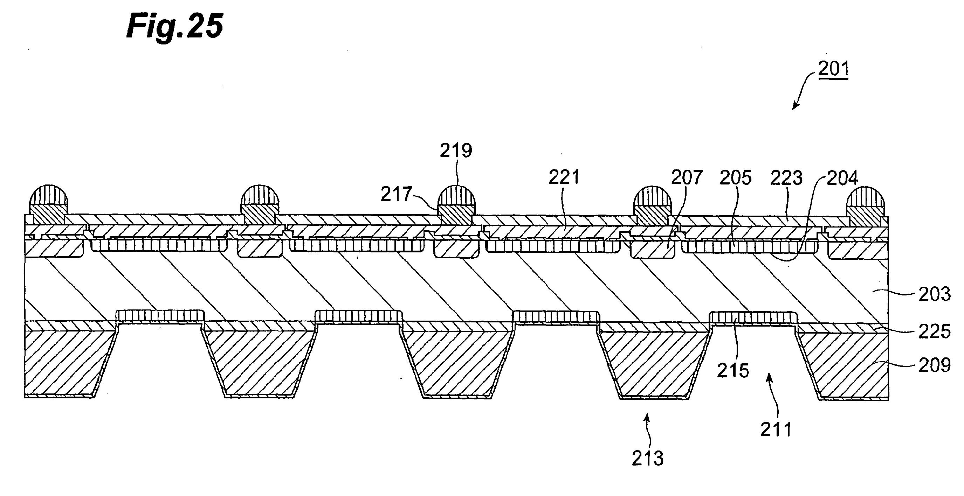

Fig. 25 is a sectional view of the photodiode array of this example. The difference in arrangement with respect to the photodiode array of the third example is that whereas in the photodiode array of the third example, the n⁺-layer and the n-layer contacted each other directly, in the present example, an SiO₂ layer 225 of 0.1 to 3µm thickness is sandwiched between the n⁺-layer and the n-layer.

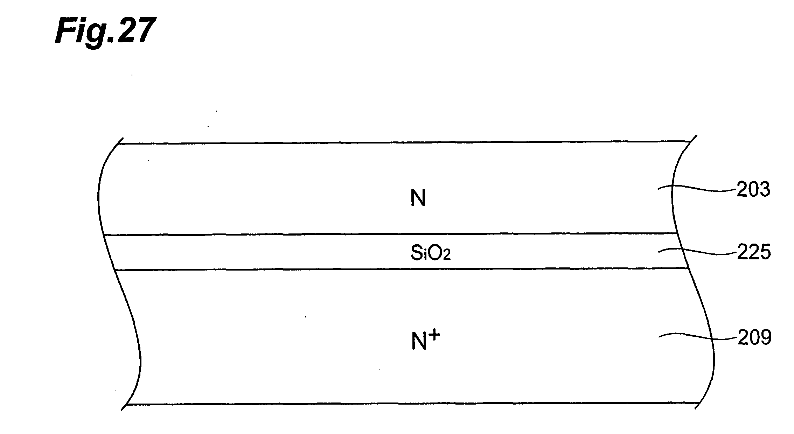

The above difference arises from a difference in the method of manufacturing the photodiode array. Whereas in the third example, an n-type silicon substrate was prepared and then an n⁺-diffused layer was formed by thermal diffusion on the back side of the substrate to prepare an n-n⁺ diffusion substrate, with the present example, an SOI (Silicon On Insulator) substrate is used as the substrate. That is, first, an n-type silicon substrate is prepared and the back side is thermally oxidized to form an SiO₂ oxide film. By then adhering an n⁺-layer with a (100) or (110) crystal plane onto the back side, an SOI substrate with a three-layer structure, such as shown in Fig. 27 is prepared and used as the substrate.

With the above-described photodiode array, since in the alkaline etching step, the etching will stop at SiO₂ layer 225, control of etching is facilitated. Also, even if carriers are generated in the n⁺-layer, SiO₂ layer 225 will not let the carriers pass through since it is an insulating layer. The generated carriers will not therefore reach the respective photosensitive pixels and crosstalk can thus be reduced further. Besides the above, the arrangement and manufacturing method are exactly the same as those of the photodiode array of the third example.

### (Fifth example)

A photodiode array of a fifth example of this invention shall now be described.

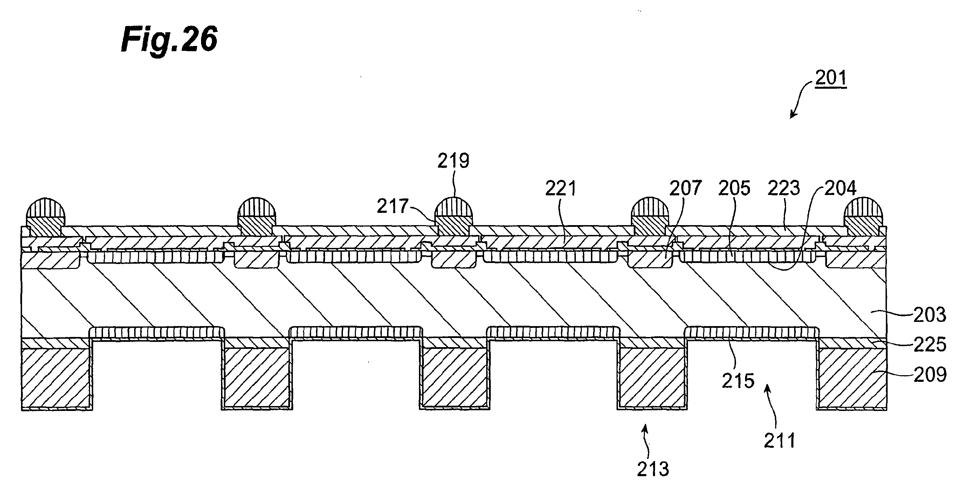

Fig. 26 is a sectional view of the photodiode array of this example. The difference in arrangement with respect to the photodiode array of the fourth example is that whereas with the photodiode array of the fourth example, each recessed part 211 at a portion corresponding to a photodiode, has its recessed part side surfaces inclined with respect to the thickness direction of the substrate so that it becomes wider towards the back side and narrower towards the front side, the recessed part side surfaces of the photodiode array of the present example are substantially parallel to the thickness direction of the substrate.

The above difference is due to a difference in the method of manufacturing the photodiode array. Whereas with the fourth example, alkaline etching is used to form recessed parts 211, in the present example, deep dry etching, using, for example, a high-density plasma, is employed.

With the above-described photodiode array, since deep dry etching is employed as the method for forming the recessed parts, the need to restrict the crystal plane of the n⁺-layer of the SOI substrate to be prepared to a (100) or (110) plane is eliminated. Also, since the etching stops at SiO₂ layer 225, control of etching is facilitated. Besides the above, the arrangement and manufacturing method are exactly the same as those of the photodiode array of the fourth example.

An example of a radiation detector shall now be described.

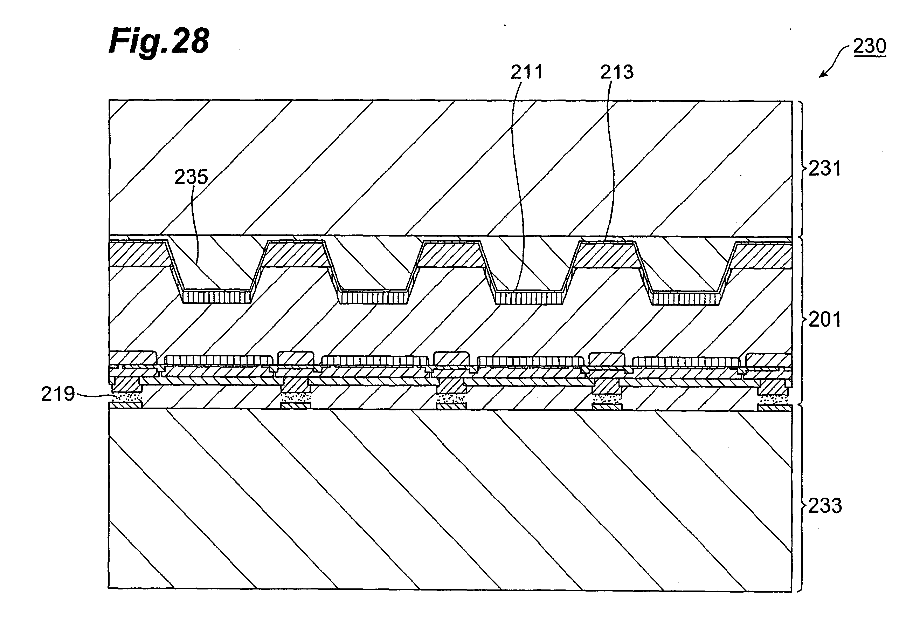

Fig. 28 is a sectional side view of the radiation detector. This radiation detector 230 is equipped with: a scintillator panel 231, onto which radiation is made incident and which emits, from a light exit surface, light resulting from the radiation; photodiode array 201, with which the light emitted from scintillator panel 231 is made incident on the light-incident surface and which converts this light into electrical signals; and a mounting wiring substrate 233.

The above-described radiation detector is characterized in being equipped with the photodiode array of this invention, and the present example is equipped with the above-described photodiode array of the second example. Thus scintillator panel 231 is installed at the back side of photodiode array 201 and is put in contact with photodiode array 201 at protruding parts 213. Though gaps thus exist between scintillator panel 231 and recessed parts 211, these gaps are filled with a coupling resin 235, having a refractive index adequate for transmission of the fluorescence from scintillator panel 231, and light emitted from scintillator panel 231 is thus arranged to be made incident onto photodiode array 201 efficiently.

Mounting wiring substrate 233 is disposed at the front side of photodiode array 201 and is electrically connected via bump electrodes 219 to photodiode array 201. With the present example, flip-chip mounting is employed, and as bump electrodes 219, metal-containing conductive bumps, such as solder bumps, gold bumps, nickel bumps, copper bumps, conductive resin bumps, etc., are used. Also as the bonding method, forms of direct bonding, filling with an underfill resin upon performing direct bonding, anisotropic conductive film (ACF) methods, anisotropic conductive paste methods (ACP), non-conductive paste (NCP) methods, etc., may be employed.

The actions of the above-described radiation detector shall now be described. In the process of bonding photodiode array 201 onto mounting wiring substrate 233, protruding parts 213 are attached by suction to a suction collet, and the protruding parts may sustain mechanical damage in this process. Carriers that give rise to dark current and noise may thus be generated from the defective parts. Also, in installing scintillator panel 231 onto the back side of photodiode array 201, scintillator panel 231 is put in contact with protruding parts 213, and protruding parts 213 may sustain mechanical damage in this process. Unnecessary carriers may be generated in this case as well. However, with the above-described radiation detector, since the photodiode array of the above-described invention is used and protruding parts 213 are arranged with n⁺-type diffused layers of high impurity concentration, the generated carriers can be made to recombine and the dark current and noise can thus be reduced.

Also with the above-described radiation detector, since protruding parts 213 are positioned between the photosensitive pixels of photodiode array 201, the incident light can be separated according to pixel. Furthermore, since protruding parts 213 are arranged with n⁺-type diffused layers of high impurity concentration, carriers, which are generated by light made incident on protruding parts 213, undergo recombination. Light that has become incident on the interval between photosensitive pixels, that is, on a protruding part 213 will thus not be taken out as a signal. Thus with the above-described radiation detector, crosstalk among the photosensitive pixels can be improved.

If with a radiation detector, a photodiode array without recesses or protrusions on the back side is to be used, the suction collet will come in direct contact with the photosensitive pixels in the process of bonding the photodiode array onto mounting wiring substrate 233. Since the scintillator panel will likewise contact the photosensitive pixels directly in the process of mounting the scintillator panel, the photosensitive pixels tend to become flawed and pixel defects are caused readily. However, with the above-described radiation detector, since the photosensitive pixel parts are positioned in recessed parts 211 and the photosensitive pixels are not contacted directly in the mounting steps, mechanical damage is unlikely to be incurred and photosensitive pixel defects can be prevented.

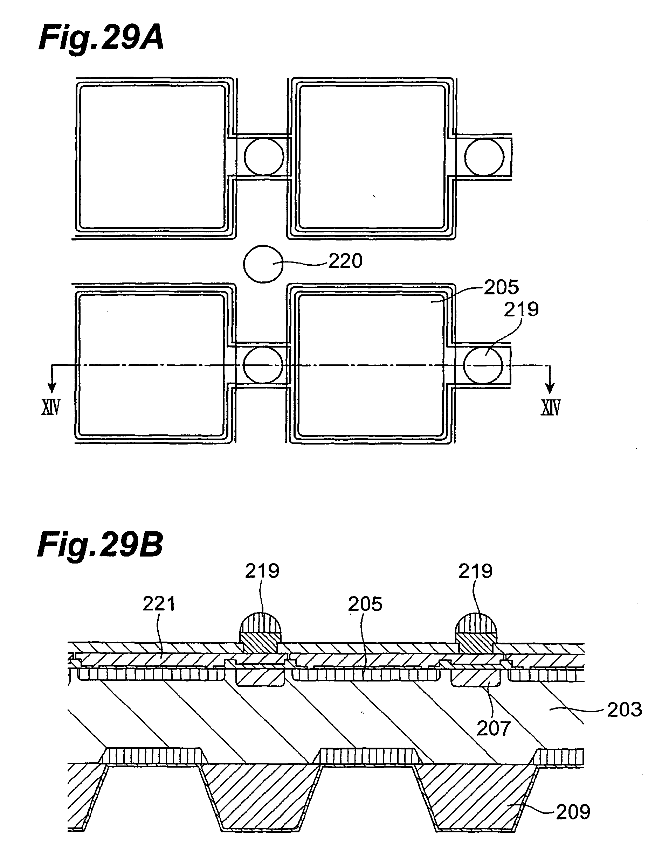

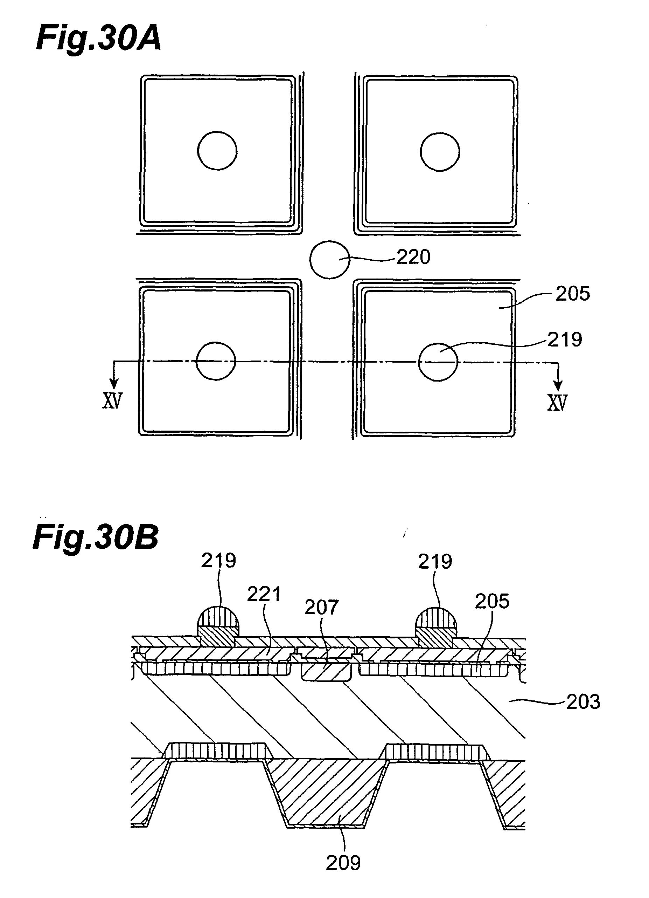

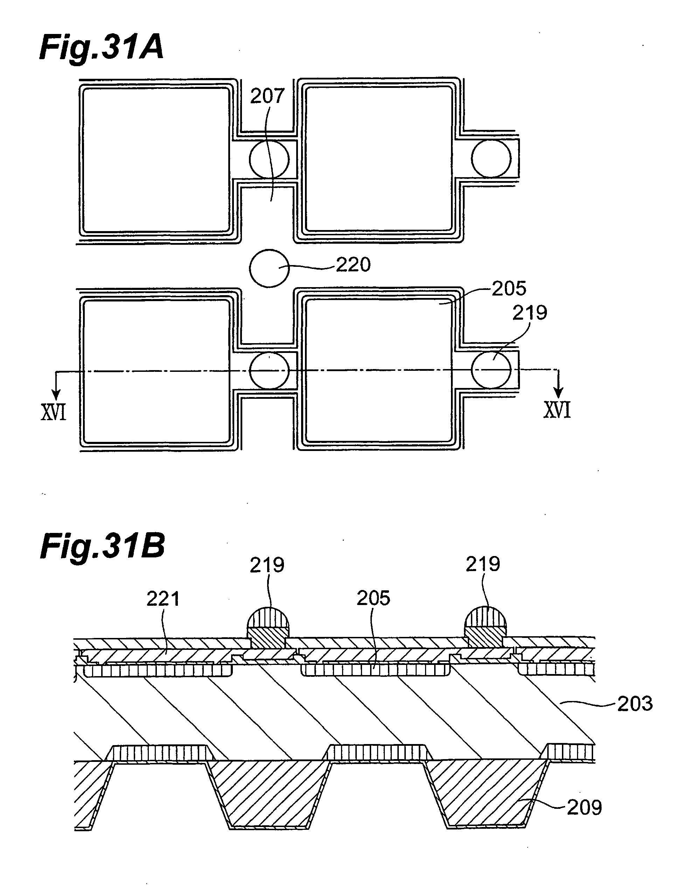

Fig. 29A is a top view showing the positional relationship of photosensitive pixel parts and bump electrodes and Fig. 29B is a sectional view taken along XIV-XIV of the photodiode array shown in Fig. 29A. Fig. 30A is a top view showing the positional relationship of photosensitive pixel parts and bump electrodes and Fig. 30B is a sectional view taken along XV-XV of the photodiode array shown in Fig. 30A. Fig. 31A is a top view showing the positional relationship of photosensitive pixel parts and bump electrodes and Fig. 31B is a sectional view taken along XVI-XVI of the photodiode array shown in Fig. 31A.

For example, though with the respective photodiode array examples described above, bump electrodes are installed on thick parts, that is, on portions corresponding to protruding parts 213 as shown in Fig. 29A and Fig. 29B to secure mechanical strength during mounting, if adequate mechanical strength can be secured, bump electrodes 219 may be installed at positions corresponding to the photosensitive pixels as shown in Fig. 30A and Fig. 30B.

Also, in the case of installing bump electrodes 219 on portions corresponding to protruding parts 213, separation layers 207 can be arranged to be interrupted just at portions corresponding to the back sides of bump electrodes 219 as shown in Fig. 31A and Fig. 31B. By doing so, shorting across an anode and a cathode can be prevented even if mechanical damage is sustained in the process of performing flip-chip mounting. Also in this case, the interrupted separation layers may be connected to each other by aluminum electrode wirings so that separation layers 207 are connected across the entirety.

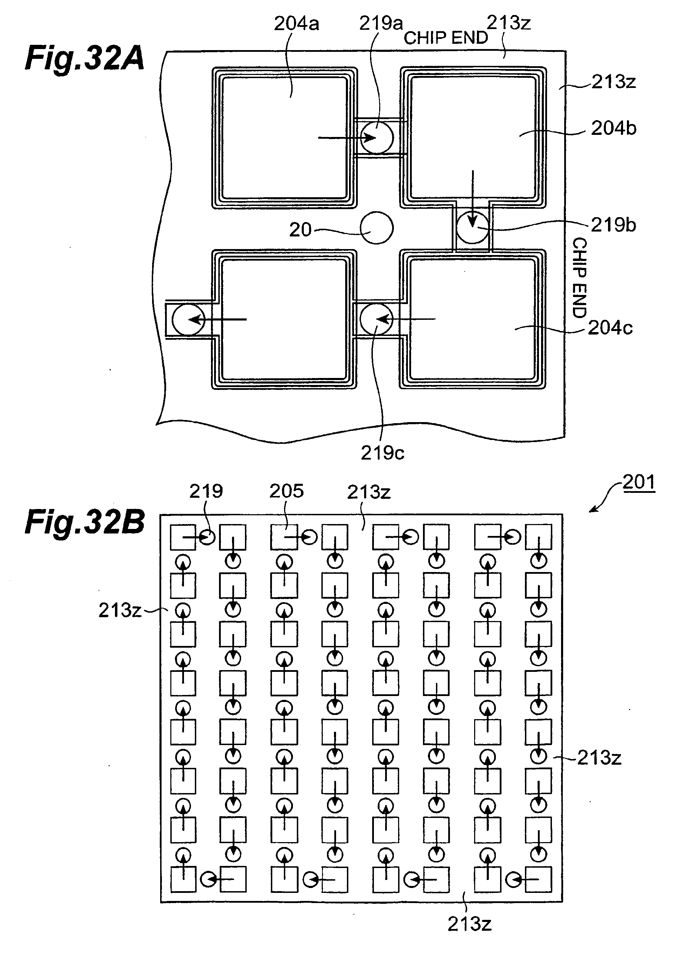

Also in the case where photosensitive elements are positioned in lattice form on a photodiode array, the photosensitive pixel area preferably extends to the very ends of the photodiode array chip. It is thus preferable to avoid installing bump electrodes at thick part regions 213z at the chip ends as shown in Fig. 17. Thus in the case where bump electrodes 219 are to be installed on the thick parts, an arrangement is possible where all bump electrodes 219 are positioned on protruding parts besides thick part regions 213z at the chip ends as shown in Fig. 32A. Fig. 32B is a top view showing the positional relationship of photosensitive pixel parts and bump electrodes at the chip ends of a photodiode array. For example, in Fig. 32A, a photosensitive pixel 204a at the upper left is positioned so as to be contacted via a bump electrode 219a to the right side thereof, a photosensitive pixel 204b at the upper left is positioned so as to be contacted via a bump electrode 219b to the lower side thereof, and a photosensitive pixel 204c at the lower right is positioned so as to be contacted via a bump electrode 219c to the left side thereof. By thus designing the positions of bump electrodes 219 so that they will not be positioned at thick part regions 213z at the chip ends, the photosensitive pixel area can be made to extend to the very ends of the photodiode array chip.

As described in detail above, with the present invention, a photodiode array can be provided with which crosstalk among elements can be reduced while maintaining the mechanical strength of the photodiode array.

### Industrial Applicability

This invention can be applied to a photodiode array and a radiation detector.

## Claims

1. A photodiode array (1) comprising:
a semiconductor substrate (5) of a first conductivity type, having a light-incident surface and an opposite side surface; and
pn junctions (3) formed at a side opposite said light-incident surface side:
wherein:
said light-incident surface has a plurality of recessed parts (7);
said opposite side surface has a plurality of recessed parts (11) immediately opposing said recesses (7) of said light-incident surface;
each of said pn junctions (3) is formed at a bottom of each of said recessed parts (11) of said opposite side surface;
a high impurity concentration accumulating layer (27) of a first conductivity type is formed at bottom of recessed parts (7) of said light-incident surface;
a high impurity concentration layer (5b) of a first conductivity type is formed at regions between said recessed parts (7) of said light-incident surface, said high impurity concentration layer (5b) having a thickness greater than a carrier diffusion length, whereby undesired carriers generated in said regions between said recessed parts (7) of said light-incident surface are trapped by said high impurity concentration layer (5b); and
electrode pads (25) for said pn junctions (3) are formed on regions between said recessed parts (11) of said opposite side surface.

2. The photodiode array (1) according to Claim 1, wherein the accumulation layer (27) has a thickness in a range of 0.1µm to a few µm.

3. The photodiode array (1) according to Claims 1 or 2,
wherein frame parts (9) are formed between said recessed parts (7) of said light-incident surface, said frame parts (9) surrounding said recessed parts (7); and wherein frame parts (13) are formed between said recessed parts (11) of said opposite side surface, said frame parts (13) surrounding said recessed parts (11).

4. The photodiode array (1) according to Claim 3,
wherein said frame parts (9) of said light-incident surface form a lattice form.

5. The photodiode array (1) according to Claims 3 or 4, wherein the pn junctions (3) extend from the bottom of the recessed parts (11) to the frame parts (13) of the opposite side surface.

6. The photodiode array (1) according to any of claims 1 to 5, wherein the area of the bottom surface of each of the recessed parts (7) of the light-incident surface is greater than the area of the bottom surface of each of the recessed parts (11) of the opposite surface side.

7. The photodiode array (1) according to any preceding Claim further comprising wiring electrodes (19) electrically connecting the photodiodes formed by said pn junctions (3) and the electrode pads (25).

8. A radiation detector comprising the photodiode array (1) according to any of Claims 1 through 7; and a scintillator (71) positioned in front of the light-incident surface of the photodiode array.

## Patentansprüche

1. Photodiodenarray (1), umfassend:
ein Halbleitersubstrat (5) eines ersten Leitfähigkeitstyps, das eine Lichteinfallsoberfläche und eine entgegengesetzte Oberfläche aufweist; und
pn-Übergänge (3), die an einer der Lichteinfallsoberflächen-Seite entgegengesetzten Seite ausgebildet sind, worin:
die Lichteinfallsoberfläche eine Mehrzahl von vertieften Teilen (7) aufweist;
die entgegengesetzte Oberfläche eine Mehrzahl von vertieften Teilen (11) aufweist, die den Vertiefungen (7) der Lichteinfallsoberfläche unmittelbar entgegengesetzt sind;
wobei jeder der pn-Übergänge (3) am Boden jedes der vertieften Teile (11) der entgegengesetzten Oberfläche ausgebildet ist;
eine Akkumulationsschicht eines ersten Leitfähigkeitstyps mit hoher Verunreinigungskonzentration (27) am Boden der vertieften Teile (7) der Lichteinfallsoberfläche ausgebildet ist;
eine Schicht (56) eines ersten Leitfähigkeitstyps mit hoher Verunreinigungskonzentration an Bereichen zwischen den vertieften Teilen (7) der Lichteinfallsoberfläche ausgebildet ist, wobei die Schicht mit hoher Verunreinigungskonzentration (5b) eine Dicke hat, die größer als eine Träger-Diffusionslänge ist, wodurch ungewünschte Träger, die in den Bereichen zwischen den vertieften Teilen (7) der Lichteinfallsoberfläche erzeugt werden, in der Schicht mit hoher Verunreinigungskonzentration (5b) gefangen werden; und Elektrodenpads (25) für die pn-Übergänge (3) an Bereichen zwischen den vertieften Teilen (11) der entgegengesetzten Oberfläche ausgebildet sind.

2. Photodiodenarray (1) nach Anspruch 1, worin die Akkumulationsschicht (27) eine Dicke im Bereich von 0,1 µm bis einige µm aufweist.

3. Photodiodenarray (1) nach Anspruch 1 oder 2, worin Rahmenteile (9) zwischen den vertieften Teilen (7) der Lichteinfallsoberfläche ausgebildet sind, die Rahmenteile (9) die vertieften Teile (7) umgeben; und Rahmenteile (13) zwischen den vertieften Teilen (11) der entgegengesetzten Oberfläche ausgebildet sind, wobei die Rahmenteile (13) die vertieften Teile (11) umgeben.

4. Photodiodenarray (1) nach Anspruch 3, worin die Rahmenteile (9) der Lichteinfallsoberfläche eine Gitterform bilden.

5. Photodiodenarray (1) nach Anspruch 3 oder 4, worin sich die pn-Übergänge (3) vom Boden der vertieften Teile (11) zu den Rahmenteilen (13) der entgegengesetzten Oberfläche erstrecken.

6. Photodiodenarray (1) nach einem der Ansprüche 1 bis 5, worin die Flächenausdehnung der Bodenoberfläche jedes der vertieften Teile (7) und der Lichteinfallsoberfläche größer ist als die Flächenausdehnung der Bodenoberfläche jedes der vertieften Teile (11) der entgegengesetzten Oberfläche.

7. Photodiodenarray (1) nach einem der vorhergehenden Ansprüche, das ferner Verdrahtungselektroden (19) aufweist, die die durch die pn-Übergänge (3) gebildeten Photodioden und die Elektrodenpads (25) elektrisch verbinden.

8. Strahlungsdetektor, umfassend das Photodiodenarray 1 nach einem der Ansprüche 1 bis 7, sowie einen Scintillator (71), der vor der Lichteinfallsoberfläche des Photodiodenarrays angeordnet ist.

## Revendications

1. Réseau (1) de photodiodes comportant :
un substrat semi-conducteur (5) d'un premier type de conductivité, ayant une surface d'incidence de lumière et une surface d'un côté opposé ; et
des jonctions pn (3) formées sur un côté opposé audit côté de la surface d'incidence de lumière ;
dans lequel :
ladite surface d'incidence de la lumière présente de multiples parties évidées (7) ;
ladite surface du côté opposé présente de multiples parties évidées (11) immédiatement opposées auxdits évidements (7) de ladite surface d'incidence de la lumière ;
chacune desdites jonctions pn (3) est formée à un fond de chacune desdites parties évidées (11) de ladite surface du côté opposé ;
une couche d'accumulation (27) à haute concentration d'impuretés d'un premier type de conductivité est formée au fond de parties évidées (7) de ladite surface d'incidence de la lumière ;
une couche (5b) à haute concentration d'impuretés d'un premier type de conductivité est formée dans des régions entre lesdites parties en creux (7) de ladite surface d'incidence de la lumière, ladite couche (5b) à haute concentration d'impuretés ayant une épaisseur supérieure à une longueur de diffusion de porteurs, grâce à quoi des porteurs indésirés générés dans lesdites régions entre lesdites parties en creux (7) de ladite surface d'incidence de la lumière sont piégés par ladite couche (5b) à haute concentration d'impuretés ; et
des plots d'électrodes (25) pour lesdites jonctions pn (3) sont formés sur des régions entre lesdites parties évidées (11) de ladite surface du côté opposé.

2. Réseau (1) de photodiodes selon la revendication 1, dans lequel la couche d'accumulation (27) a une épaisseur dans la plage de 0,1 µm à quelques µm.

3. Réseau (1) de photodiodes selon la revendication 1 ou 2,
dans lequel des parties de cadre (9) sont formées entre lesdites parties évidées (7) de ladite surface d'incidence de la lumière, lesdites parties de cadre (9) entourant lesdites parties évidées (7) ; et dans lequel des parties de cadre (13) sont formées entre lesdites parties évidées (11) de ladite surface du côté opposé, lesdites parties de cadre (13) entourant lesdites parties évidées (11).

4. Réseau (1) de photodiodes selon la revendication 3,
dans lequel lesdites parties de cadre (9) de ladite surface d'incidence de la lumière forment un treillis.

5. Réseau (1) de photodiodes selon la revendication 3 ou 4, dans lequel les jonctions pn (3) s'étendent depuis le fond des parties évidées (11) jusqu'aux parties de cadre (13) de la surface du côté opposé.

6. Réseau (1) de photodiodes selon l'une quelconque des revendications 1 à 5, dans lequel l'aire de la surface de fond de chacune des parties évidées (7) de la surface d'incidence de la lumière est plus grande que l'aire de la surface de fond de chacune des parties évidées (11) du côté de surface opposé.

7. Réseau (1) de photodiodes selon l'une quelconque des revendications précédentes, comportant en outre des électrodes de câblage (19) connectant électriquement les photodiodes formées par lesdites jonctions pn (3) et les plots d'électrodes (25).

8. Détecteur de rayonnement comportant le réseau (1) de photodiodes selon l'une quelconque des revendications 1 à 7 ; et un scintillateur (71) positionné en face de la surface d'incidence de la lumière du réseau de photodiodes.
